(19) Europäisches Patentamt
European Patent Office
Office européen des brevets

(11) **EP 3 380 851 B1**

(12) **EUROPÄISCHE PATENTSCHRIFT**

(45) Veröffentlichungstag und Bekanntmachung des Hinweises auf die Patenterteilung:
**11.05.2022  Patentblatt 2022/19**

(21) Anmeldenummer: **16798162.0**

(22) Anmeldetag: **18.11.2016**

(51) Internationale Patentklassifikation (IPC):
**G01R 1/20** *(2006.01)*        **G01R 1/44** *(2006.01)*

(52) Gemeinsame Patentklassifikation (CPC):
**G01R 1/203;** G01R 1/44; Y02E 60/10

(86) Internationale Anmeldenummer:
**PCT/EP2016/078092**

(87) Internationale Veröffentlichungsnummer:
**WO 2017/089228 (01.06.2017 Gazette 2017/22)**

(54) **STROMSENSOR**

CURRENT SENSOR

CAPTEUR DE COURANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.11.2015  DE 102015223526**

(43) Veröffentlichungstag der Anmeldung:
**03.10.2018  Patentblatt 2018/40**

(73) Patentinhaber: **Robert Bosch GmbH**
**70442 Stuttgart (DE)**

(72) Erfinder:
• **THOELMANN, Karsten**
**71696 Moeglingen (DE)**
• **KAUPP, Patrick**
**70469 Stuttgart (DE)**
• **REIMER, Eduard**
**70374 Stuttgart (DE)**
• **TZIVANOPOULOS, Chrysanthos**
**71686 Remseck am Neckar (DE)**
• **LORENZ, Lisa**
**70176 Stuttgart (DE)**
• **BERGMANN, Sven**
**70437 Stuttgart (DE)**
• **LEUNG, Kuen Cheuk**
**Rochester Hills**
**MI 48306 (US)**
• **RUEHLE, Andreas**
**74321 Bietigheim-Bissingen (DE)**

(56) Entgegenhaltungen:
DE-A1-102004 042 719    DE-A1-102007 033 182
DE-A1-102010 009 835    DE-A1-102013 210 128
DE-A1-102014 103 343    US-A- 6 028 426

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die vorliegende Erfindung betrifft einen Stromsensor mit einem Stromleiter, durch den ein erster Strom parallel zu einer ersten Richtung fließen kann. Auch betrifft die Erfindung eine Leiterplatteneinheit mit einer Leiterplatte und einem solchen auf der Leiterplatte angeordneten Stromsensor. Ferner betrifft die Erfindung eine Batterie mit mehreren jeweils wenigstens eine Batteriezelle aufweisenden Batteriemodulen und wenigstens einem zuvor genannten Stromsensor. Dabei umfasst die Batterie bevorzugt wenigstens eine zuvor genannte Leiterplatteneinheit mit wenigstens einer Leiterplatte, auf welcher der wenigstens eine Stromsensor angeordnet ist.

Stand der Technik

Aus dem Stand der Technik ist ein Stromsensor mit einem Stromleiter bekannt, durch den ein erster Strom parallel zu einer ersten Richtung fließen kann. Dabei ist der Stromsensor dazu ausgebildet, einen aktuellen Stromwert des ersten Stromes zu bestimmen.

Aus dem Dokument DE 10 2009 011 538 A1 ist eine Leiterplatteneinheit bekannt, welche eine Klebstoffzusammensetzung umfasst. Die Klebstoffzusammensetzung weist dabei eine gute elektrische Leitfähigkeit auf.

Aus demselben Dokument sind elektronische Schaltkreise bekannt, welche in der Regel durch Aufbringung einer Kupferschicht auf einem Substrat hergestellt werden.

Aus dem Dokument DE 10 2008 061 051 A1 ist eine Leiterplatteneinheit mit einer elektrisch leitfähigen Leiterbahn und einem elektronischen Bauelement bekannt.

Dabei weisen die Leiterbahnen eine Kupferschicht auf. Darüber hinaus ist aus demselben Dokument eine Leiterplatteneinheit mit einem elektronischen Bauelement bekannt, welches durch eine Klebstoffzusammensetzung mit mindestens einer elektrisch leitfähigen Leiterbahn einer Leiterplatte der Leiterplatteneinheit verbunden ist.

Aus dem Dokument DE 697 32 004 T2 ist ein Klebeband beziehungsweise eine Klebefolie bekannt, welche als Klebeschicht für ein halbleiterverbindendes Substrat geeignet ist. Dabei weist die Klebeschicht eine Kupferfolie zur verbesserten Leitfähigkeit auf. Die Klebeschicht wird zum Montieren einer integrierten Halbleiterschaltung verwendet.

Aus DE 10 2014 103343 A1 ist eine Mehrfach-Stromsensorvorrichtung bekannt.

Offenbarung der Erfindung

Erfindungsgemäß wird ein Stromsensor mit einem Stromleiter, durch den ein erster Strom parallel zu einer ersten Richtung fließen kann, mit den Merkmalen des Anspruchs 1 bereitgestellt. Der Stromleiter umfasst drei entlang der ersten Richtung unmittelbar aufeinanderfolgende Bereiche. Dabei weist ein mittlerer Bereich der drei Bereiche eine Leiterquerschnittsfläche auf, die kleiner als eine Leiterquerschnittsfläche eines jeden von zwei äußeren Bereichen der drei Bereiche ist. Ein Spannungssensor des Stromsensors umfasst zwei Terminals und ist dazu ausgebildet, eine zwischen den zwei Terminals anliegende erste Spannung zu messen. Die zwei Terminals sind derartig angeordnet, dass eine minimale elektrisch leitende Verbindungsstrecke zwischen den zwei Terminals teilweise über einen Messbereich verläuft und die erste Spannung gleich einer über dem Messbereich abfallenden Spannung ist. Dabei stimmt der Messbereich mit dem mittleren Bereich oder mit einem Teilbereich des mittleren Bereichs überein. Ferner ist eine Auswerteeinheit des Stromsensors dazu ausgebildet, einen aktuellen Stromwert des ersten Stroms in Abhängigkeit von einem aktuellen Spannungswert der ersten Spannung und von einem vordefinierten Widerstandswert eines ersten Widerstands des Messbereichs zu bestimmen.

Die Unteransprüche zeigen bevorzugte Weiterbildungen der Erfindung.

Gemäß einer ersten bevorzugten Weiterbildung der Erfindung umfassen die zwei äußeren Bereiche eine jeweils andere von zwei sich senkrecht zur ersten Richtung erstreckenden Enden des Stromleiters. Dabei erstreckt sich eine jede Kontaktfläche zwischen dem mittleren Bereich und einem der zwei äußeren Bereiche senkrecht zur ersten Richtung. Ferner ist ein Leiterquerschnittsverlauf des Stromleiters entlang der ersten Richtung an jeder Kontaktfläche unstetig.

Gemäß einer zweiten bevorzugten Weiterbildung der Erfindung ist ein Quotient zwischen der Leiterquerschnittsfläche des mittleren Bereichs und der Leiterquerschnittsfläche jedes der zwei äußeren Bereiche kleiner oder gleich einem zwischen 0,1 und 0,9 liegenden ganzzahligen Vielfaches von 0,1. Alternativ oder zusätzlich ist ein Quotient zwischen einer sich parallel zur ersten Richtung erstreckenden Länge des mittleren Bereichs und der Leiterquerschnittsfläche des mittleren Bereichs kleiner als ein Produkt zwischen 1,6 und einem Kehrwert einer ersten Längeneinheit. Dabei stimmt eine Längeneinheit, in der die Länge des mittleren Bereichs angegeben wird, mit der ersten Längeneinheit überein. Ferner stimmt eine Flächeneinheit, in der die Leiterquerschnittsfläche des mittleren Bereichs angegeben wird, mit der ersten Längeneinheit zum Quadrat überein. Die zweite bevorzugte Weiterbildung kann mit der ersten bevorzugten Weiterbildung und/oder deren Ausgestaltungen kombiniert werden.

Gemäß einer dritten bevorzugten Weiterbildung der Erfindung ist der Stromleiter plattenförmig. Alternativ oder zusätzlich ist ein Höhenverlauf des Stromleiters entlang der ersten Richtung konstant. Die dritte bevorzugte Weiterbildung kann mit einer oder mehreren der anderen zuvor beschriebenen bevorzugten Weiterbildungen und/oder deren Ausgestaltungen kombiniert werden.

Gemäß einer vierten bevorzugten Weiterbildung der Erfindung weist der Stromleiter in einem parallel zur ersten Richtung verlaufenden Randbereich eine Aussparung auf, deren Kontur aus drei unmittelbar aufeinander folgenden Teilkonturen besteht. Dabei grenzen eine erste und eine zweite der Teilkonturen jeweils unmittelbar an einen anderen der zwei äußeren Bereiche an. Ferner verläuft eine dritte der Teilkonturen parallel zu der ersten Richtung und grenzt unmittelbar an den mittleren Bereich an. Die vierte bevorzugte Weiterbildung kann mit einer oder mehreren der anderen zuvor beschriebenen bevorzugten Weiterbildungen und/oder deren Ausgestaltungen kombiniert werden.

Bei einem zuvor beschriebenen Stromsensor gemäß der vierten bevorzugten Weiterbildung verlaufen die erste und/oder die zweite Teilkontur bevorzugt jeweils zumindest teilweise in einen spitzen, rechten oder stumpfen Winkel gegenüber der ersten Richtung. Jeder zuvor genannte spitze Winkel kann beispielsweise einen Winkelwert aufweisen, der bevorzugt zwischen 45° und 90° und weiter bevorzugt zwischen 55° und 85° liegt. Jeder zuvor genannte stumpfe Winkel kann beispielsweise einen Winkelwert aufweisen, der bevorzugt zwischen 90° und 135° und weiter bevorzugt zwischen 95° und 130° liegt. Ferner können die erste und/oder die zweite Teilkontur jeweils zumindest teilweise einen linienförmigen Verlauf aufweisen. Alternativ oder zusätzlich können die erste und/oder die zweite Teilkontur jeweils zumindest teilweise einen kurvenförmigen Verlauf aufweisen.

Bei einem zuvor beschriebenen bevorzugten Stromsensor ist die Leiterquerschnittsfläche des mittleren Bereichs des Stromleiters und folglich auch des Messbereichs kleiner als die Leiterquerschnittsfläche jedes der zwei äußeren Bereiche des Stromleiters. Folglich ist der erste Widerstand des Messbereichs eines zuvor beschriebenen Sensors größer als in einem Fall, in dem die Leiterquerschnittsfläche des Messbereichs größer oder gleich der Leiterquerschnittsfläche jedes der zwei äußeren Bereiche des Stromleiters ist. Vorteilhaft dabei ist, dass eine Vergrößerung des ersten Widerstands des Messbereichs zu einer Vergrößerung von Spannungswerten der über dem Messbereich abfallenden Spannung und folglich zu einer Vergrößerung von mittels des Spannungssensors zu messenden Spanungswerten der ersten Spannung führt. Dabei führt die Vergrößerung der mittels des Spannungssensors zu messenden Spanungswerte der ersten Spannung zu einer Senkung eines relativen Messfehlers der mittels des Spannungssensors zu messenden Spannungswerte der ersten Spannung.

Gemäß einer fünften bevorzugten Weiterbildung der Erfindung stimmt der Messbereich mit dem mittleren Bereich überein. Dabei sind die zwei Terminals jeweils in einem anderen der zwei äußeren Bereiche angeordnet. Ferner verläuft die minimale elektrisch leitende Verbindungsstrecke zwischen den zwei Terminals vollständig über den Stromleiter. Alternativ stimmt der Messbereich mit dem mittleren Bereich oder mit dem Teilbereich des mittleren Bereichs überein. Dabei sind die zwei Terminals außerhalb des Stromleiters angeordnet. Ferner sind Teile der minimalen elektrisch leitenden Verbindungsstecke, die nicht über den Messbereich verlaufen, als Messleitungen ausgebildet, die außerhalb des Stromleiters verlaufen. Die fünfte bevorzugte Weiterbildung kann mit einer oder mehreren der anderen zuvor beschriebenen bevorzugten Weiterbildungen und/oder deren Ausgestaltungen kombiniert werden.

Bei einem zuvor beschriebenen Stromsensor verläuft die minimale elektrisch leitende Verbindungsstrecke zwischen den zwei Terminals des Spannungssensors teilweise über den Messbereich. Ferner ist die zwischen den zwei Terminals anliegende erste Spannung gleich der über dem Messbereich abfallenden Spannung. Folglich fällt über Teilen der minimalen Verbindungsstrecke zwischen den zwei Terminals, die nicht über den Messbereich verlaufen, keine Spannung ab. Das bedeutet, dass in einem zuvor beschriebenen, bevorzugten Fall, in dem die zwei Terminals jeweils in einem anderen der zwei äußeren Bereiche des Stromleiters angeordnet sind, die Teile der minimalen Verbindungsstrecke zwischen den Terminals, die nicht über den Messbereich verlaufen, sich senkrecht zu der ersten Richtung erstrecken. Um dies in einem solchen Fall auch dann erreichen zu können, wenn zusätzlich die Leiterquerschnittfläche des Stromleiters unstetig ist, sind die zwei Terminals in einem Teilrandbereich eines jeweils anderen der zwei äußeren Bereiche des Stromleiters anzuordnen. Dabei umfasst der Teilrandbereich jedes äußeren Bereichs eine unmittelbar an eine äußere Außenumgebung des Stromleiters angrenzende Teilfläche einer an den mittleren Bereich unmittelbar angrenzenden Fläche des jeweiligen äußeren Bereichs. Eine in den Teilrandbereichen der zwei äußeren Bereiche jeweils vorkommende Stromdichte des ersten Stromes ist vernachlässigbar klein. Insbesondere ist die in den Teilrandbereichen der zwei äußeren Bereiche jeweils vorkommende Stromdichte des ersten Stromes um mehrere Größenordnungen kleiner als eine in übrigen Bereichen des Stromleiters vorkommende Stromdichte des ersten Stroms. Folglich fließt kein Strom über die in den zwei Teilrandbereichen angeordneten Terminals. Auch in einem zuvor beschriebenen, bevorzugten Fall, in dem die zwei Terminals außerhalb des Stromleiters angeordnet sind, fließt kein Strom über die Terminals, da hier über den zwei Messleitungen, die sich außerhalb des Stromleiters erstrecken, keine Spannung abfällt. Wenn kein Strom über die zwei Terminals fließt, können der Stromleiter und die Terminals in vorteilhafter Weise auch aus zwei unterschiedlichen Materialien bestehen, ohne dass eine nachfolgend diskutierte Beeinträchtigung der zwei Terminals auftritt. Beispielsweise können die Terminals aus Kupfer und der Stromleiter aus Aluminium bestehen. Der Grund für die Beeinträchtigung ist, dass, wenn der Stromleiter und die zwei Terminals aus zwei unterschiedlichen Materialien bestehen, ein über die zwei Terminals fließender Strom ein lokales Schmelzen der Terminals und folglich eine Diffusion der zwei unterschiedlichen Materialien ineinander verursachen kann.

Gemäß der Erfindung umfasst der Stromsensor zwei jeweils insbesondere als Heißleiter ausgebildete Temperatursensoren. Dabei steht ein jeder der Temperatursensoren in thermischem Kontakt mit jeweils einem diesem zugeordneten Ende von zwei sich senkrecht zur ersten Richtung erstreckenden Enden des Messbereichs. Ferner ist jeder Temperatursensor dazu ausgebildet, eine Temperatur des diesem zugeordneten Endes des Messbereichs zu messen. Auch ist die Auswerteeinheit dazu ausgebildet, den aktuellen Stromwert des ersten Stroms ferner in Abhängigkeit von zwei Parametern zu bestimmen, die jeweils von einem aktuellen Temperaturwert der von einem anderen der Temperatursensoren gemessenen Temperatur abhängig sind.

Gemäß einer siebten bevorzugten Weiterbildung der Erfindung besteht der Stromleiter aus einem ersten Material. Dabei ist die Auswerteeinheit dazu ausgebildet, den aktuellen Stromwert des ersten Stroms als einen Quotienten zwischen einem aktuellen Spannungswert einer zweiten Spannung und einem aktuellen Widerstandswert des ersten Widerstands zu bestimmen. Die Auswerteeinheit ist dazu ausgebildet, den aktuellen Spannungswert der zweiten Spannung gleich dem aktuellen Wert der ersten Spannung zu setzen, wenn die zwei Terminals außerhalb des Stromleiters angeordnet sind oder wenn die zwei Terminals innerhalb des Stromleiters angeordnet sind und aus dem ersten Material bestehen. Die Auswerteeinheit ist dazu ausgebildet, den aktuellen Spannungswert der zweiten Spannung in Abhängigkeit von dem aktuellen Spannungswert der ersten Spannung und den zwei Parametern zu bestimmen, wenn die zwei Terminals innerhalb des Stromleiters angeordnet sind und aus einem gegenüber dem ersten Material unterschiedlichen zweiten Material bestehen. Weiterhin ist die Auswerteeinheit dazu ausgebildet, den aktuellen Widerstandswert des ersten Widerstands in Abhängigkeit von dem vordefinierten Widerstand des ersten Widerstands und den zwei Parametern zu bestimmen. Die siebte bevorzugte Weiterbildung kann mit einer oder mehreren der anderen zuvor beschriebenen bevorzugten Weiterbildungen und/oder deren Ausgestaltungen kombiniert werden.

Bei einem zuvor beschriebenen Stromsensor kann der Stromleiter über seine zwei äußeren Bereiche in einen Stromkreis eingebunden werden. Dabei können die zwei äußeren Bereiche des Stromleiters derartig unterschiedlich ausgebildete Verbindungen zu dem Stromkreis aufweisen, dass, wenn der Stromkreis von dem ersten Strom durchflossen wird, sich Temperaturen der zwei äußeren Bereiche deutlich voneinander unterscheiden. Da der Messbereich in thermischem Kontakt mit den zwei äußeren Bereichen steht, unterscheiden sich in einem solchen Fall folglich auch die Temperaturen der zwei senkrecht zur ersten Richtung erstreckenden Enden des Messbereichs untereinander. Bei einem Stromsensor gemäß der siebten Ausführungsform der Erfindung werden die Temperaturen der zwei zuvor genannten Enden des Messbereichs mittels der zwei Temperatursensoren gemessen und bei der Bestimmung des aktuellen Stromwerts des ersten Stroms berücksichtigt. Dadurch wird eine Genauigkeit der Bestimmung des aktuellen Stromwerts des ersten Stroms erhöht.

Gemäß einer achten bevorzugten Weiterbildung der Erfindung ist die Auswerteeinheit dazu ausgebildet, in einem Fall, in dem die zwei Terminals innerhalb des Stromleiters angeordnet sind und aus dem zweiten Material bestehen, einen aktuellen Spannungswert einer zwischen den zwei Enden des Messbereichs anliegenden Seebeck-Thermospannung zu bestimmen. In diesem Fall ist die Auswerteeinheit dazu ausgebildet, den aktuellen Spannungswert der zwischen den zwei Enden des Messbereichs anliegenden Seebeck-Thermospannung in Abhängigkeit von Seebeck-Koeffizienten des ersten und des zweiten Materials und von den zwei Parametern zu bestimmen. In diesem Fall, ist die Auswerteeinheit auch dazu ausgebildet, den aktuellen Spannungswert der zweiten Spannung als lineare Kombination zwischen dem aktuellen Spannungswert der ersten Spannung und dem aktuellen Spannungswert der Seebeck-Thermospannung zu bestimmen. Die achte bevorzugte Weiterbildung kann mit einer oder mehreren der anderen zuvor beschriebenen bevorzugten Weiterbildungen und/oder deren Ausgestaltungen kombiniert werden.

Bei einem Stromsensor gemäß der achten Ausführungsform der Erfindung werden auch die Seebeck-Koeffizienten des ersten und des zweiten Materials bei der Bestimmung des aktuellen Stromwerts des ersten Stroms berücksichtigt, wenn die zwei Terminals innerhalb des Stromleiters angeordnet sind und aus dem zweiten Material bestehen. Dadurch wird eine Genauigkeit der Bestimmung des aktuellen Stromwerts des ersten Stroms weiter erhöht.

Gemäß einer neunten bevorzugten Weiterbildung der Erfindung ist die Auswerteeinheit dazu ausgebildet, einen in dem Messbereich vorkommenden Temperaturgradienten zu bestimmen und einen aktuellen Temperaturwert einer durchschnittlichen Temperatur des Messbereichs in Abhängigkeit von dem Temperaturgradienten und den zwei Parametern zu bestimmen. Ferner ist die Auswerteeinheit dazu ausgebildet, den aktuellen Widerstandswert des ersten Widerstands in Abhängigkeit von dem aktuellen und einem vordefinierten Temperaturwert der durchschnittlichen Temperatur des Messbereichs, von einem Temperatur-Koeffizienten des ersten Materials und dem vordefinierten Widerstandswert des ersten Widerstandswerts zu bestimmen. Dabei stimmt der aktuelle Widerstandswert des ersten Widerstands mit einem bei dem aktuellen Temperaturwert der durchschnittlichen Temperatur des Messbereichs vorkommenden Widerstandswerts des ersten Widerstands überein. Ferner stimmt der vordefinierte Widerstandswert des ersten Widerstands mit dem bei dem vordefinierten Temperaturwert der durchschnittlichen Temperatur des Messbereichs vorkommenden Widerstandswert des ersten Widerstands überein. Die neunte bevorzugte Weiterbildung kann mit einer oder mehreren der anderen zuvor beschriebenen bevorzugten Weiterbildungen und/oder deren Ausgestaltungen kombiniert werden.

Bei einem Stromsensor gemäß der neunten Ausführungsform der Erfindung werden auch der in dem Messbereich vorkommenden Temperaturgradient und der Temperatur-Koeffizient des ersten Materials bei der Bestimmung des aktuellen Stromwerts des ersten Stroms berücksichtigt. Dadurch wird eine Genauigkeit der Bestimmung des aktuellen Stromwerts des ersten Stroms weiter erhöht.

Bei einem Stromsensor gemäß einer zehnten Ausführungsform der Erfindung ist die Auswerteeinheit dazu ausgebildet, einen aktuellen Temperaturmessfehler jedes Temperatursensors in Abhängigkeit von einem zeitabhängigen aktuellen Verlauf der von dem jeweiligen Temperatursensor gemessenen Temperatur und von einem zeitabhängigen aktuellen Verlauf einer gewünschten Temperatur zu bestimmen. Die bei einer Bestimmung des aktuellen Temperaturmessfehlers jedes Temperatursensors vorkommende gewünschte Temperatur ist diejenige Temperatur, die von dem jeweiligen Temperatursensor in Abwesenheit eines thermischem Übergangswiderstands zwischen dem jeweiligen Temperatursensor und dem diesem zugeordneten Ende des Messbereichs gemessen werden würde. Die Auswerteeinheit ist weiter dazu ausgebildet, für jeden Temperatursensor einen aktuellen Temperaturwert einer korrigierten Temperatur des dem jeweiligen Temperatursensor zugeordneten Endes des Messbereichs in Abhängigkeit von dem aktuellen Temperaturwert der von dem jeweiligen Temperatursensor gemessenen Temperatur und von dem aktuellen Temperaturmessfehler des jeweiligen Temperatursensors zu bestimmen. Dabei stimmen die zwei Parameter jeweils mit einem aktuellen Temperaturwert der korrigierten Temperatur eines jeweils anderen der den Temperatursensoren zugeordneten Enden des Messbereichs überein. Die zehnte bevorzugte Weiterbildung kann mit einer oder mehreren der anderen zuvor beschriebenen bevorzugten Weiterbildungen und/oder deren Ausgestaltungen kombiniert werden.

Bei einem Stromsensor gemäß der zehnten Ausführungsform der Erfindung werden auch aktuelle Temperaturmessfehler der Temperatursensoren bei der Bestimmung des aktuellen Stromwerts des ersten Stroms berücksichtigt.

Dadurch wird eine Genauigkeit der Bestimmung des aktuellen Stromwerts des ersten Stroms weiter erhöht.

Ein zuvor beschriebener Stromsensor kann zwischen zwei laminierten Polymerfolien angeordnet werden oder als Teil eines Stanzgitters hergestellt werden.

Ein weiterer Aspekt betrifft eine Leiterplatteneinheit mit einer Leiterplatte, einem zuvor beschriebenen Stromsensor und einem Kontaktelement. Dabei ist der Stromsensor auf der Leiterplatte aufgebracht. Ferner ist das Kontaktelement an der Leiterplatte angebracht. Auch weist das Kontaktelement eine Leiste aus elektrisch leitfähigem Material, insbesondere aus Kupfer, und eine doppelseitige Klebevorrichtung mit zwei gegenüberliegenden Klebeflächen auf. Weiterhin ist die Leiste mit einem ersten der zwei äußeren Bereiche des Stromleiters des Stromsensors verbunden. Ferner ist die Klebevorrichtung über eine erste der zwei Klebeflächen auf der Leiste geklebt. Auch ist ein für die Klebevorrichtung verwendeter Klebstoff aus einem elektrisch leitfähigen Material ausgebildet.

Vorteilhaft bei der zuvor beschriebenen Leiterplatteneinheit ist, dass der auf der Leiterplatte aufgebrachte Stromsensor über eine zweite der zwei Klebeflächen der Klebevorrichtung in einfacher und kostengünstiger Weise in einem Stromkreis, der durch den erste Strom durchflossen werden kann, eingebunden werden kann.

Ein anderer Aspekt betrifft eine Batterie mit mehreren in Reihe geschalteten und jeweils wenigstens eine Batteriezelle aufweisenden Batteriemodulen und wenigstens einem zuvor beschriebenem Stromsensor, der jeweils einem der Batteriemodule zugeordnet ist. Ein jeder des wenigstens einen Stromsensors ist über einen ersten der zwei äußeren Bereiche seines Stromleiters mit einem Batteriezellterminal einer vorbestimmten Batteriezelle des diesem zugeordneten Batteriemoduls verbunden und über einen zweiten der zwei äußeren Bereiche seines Stromleiters mit einem Verbindungsanschluss des diesem zugeordneten Batteriemoduls verbunden. Dabei sind die Batteriemodule über ihre Verbindungsanschlüsse miteinander verbunden. Ferner kann der erste Strom gleichzeitig durch die Batterie und den Stromleiter jedes Stromsensors fließen. Dabei kann jeder einem des wenigstens einen Batteriemoduls zugeordneten Stromsensor einstückig mit dem Verbindungsanschluss des diesem zugeordneten Batteriemoduls ausgebildet sein. Jeder einem Batteriemodul des wenigstens einen Batteriemoduls zugeordneten Stromsensor kann als ein separates Einzelstück, das heißt getrennt von dem Verbindungsanschluss des diesem zugeordneten Batteriemoduls, ausgebildet sein.

Die zuvor beschriebene Batterie umfasst bevorzugt wenigsten eine zuvor beschriebene Leiterplatteneinheit. Dabei ist eine jede der wenigstens einen Leiterplatteneinheit jeweils demjenigen der Batteriemodule zugeordnet, dem auch der auf der Leiterplatte der jeweiligen Leiterplatteneinheit aufgebrachte Stromsensor zugeordnet ist. Dabei ist ferner das Kontaktelement jeder Leiterplatteneinheit über eine zweite der zwei Klebeflächen seiner Klebevorrichtung an dem Batteriezellterminal der vorbestimmten Batteriezelle des der jeweiligen Leiterplatteneinheit zugeordneten Batteriemoduls geklebt.

Kurze Beschreibung der Zeichnungen

Nachfolgend werden Ausführungsbeispiele der Erfindung unter Bezugnahme auf die begleitenden Zeichnungen im Detail beschrieben. Für gleiche Komponenten und Parameter werden jeweils gleiche Bezugszeichen verwendet. Jede Komponente und jeder Parameter werden jeweils einmalig eingeführt und bei Wiederholung jeweils als schon bekannt behandelt, unabhängig davon, auf welche Zeichnung oder auf welches Ausführungsbeispiel sich ein jeweils entsprechender Beschreibungsteil, in dem die entsprechende Komponente oder der entsprechende Parameter wiederholt vorkommt, bezieht. In den Zeichnungen ist:

Figur 1    eine perspektivische Ansicht eines Stromleiters eines Stromsensors gemäß einer ersten Ausführungsform der Erfindung,

Figur 2    ein zeitabhängiger Verlauf einer ersten Temperatur, die mittels eines ersten Temperatursensors des Stromsensors gemäß der ersten Ausführungsform gemessen wird, und weitere zeitabhängige Temperaturverläufe,

Figur 3    eine perspektivische Teilansicht eines ersten Batteriemoduls mit einem Stromsensor gemäß der ersten Ausführungsform der Erfindung,

Figur 4    eine perspektivische Teilansicht eines zweiten Batteriemoduls mit einem Stromsensor gemäß einer zweiten Ausführungsform der Erfindung,

Figur 5    eine Leiterplatte mit einem Stromsensor gemäß der ersten oder der zweiten Ausführungsform der Erfindung, und

Figur 6    eine Seitenansicht eines dritten Batteriemoduls mit einer in der Figur 5 dargestellten Leiterplatteneinheit.

Ausführungsformen der Erfindung

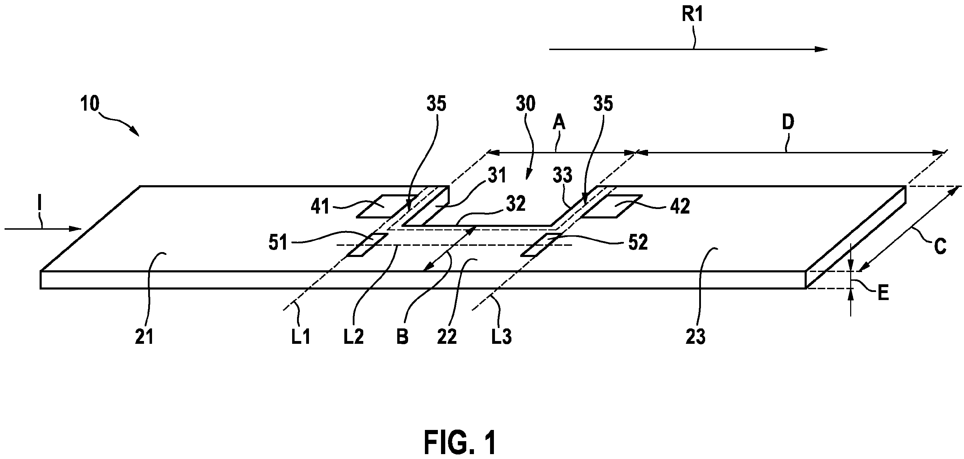

Figur 1 zeigt eine perspektivische Ansicht eines plattenförmigen Stromleiters 10 eines Stromsensors gemäß einer ersten Ausführungsform der Erfindung. Durch den Stromleiter 10 kann ein erster Strom I parallel zu einer ersten Richtung R1 fließen. Folglich kann der erste Strom I entlang der ersten Richtung R1 fließen. Alternativ kann der erste Strom I entgegengesetzt zu der ersten Richtung R1 fließen. Der erste Strom I kann während eines Durchfließens des Stromleiters 10 einen maximalen Stromwert von beispielsweise 450 A während eines Zeitraumes mit einer Dauer von beispielsweise 10 s annehmen.
Der Stromleiter 10 besteht aus einem ersten Material, beispielsweise aus Aluminimum (AL3003 H18).
Der Stromleiter 10 ist plattenförmig und weist eine Länge auf, die parallel zur ersten Richtung R1 verläuft. Ferner umfasst der Stromleiter 10 drei entlang der ersten Richtung R1 unmittelbar aufeinanderfolgende Bereiche 21, 22, 23, die einen mittleren Bereich 22 und zwei äußere Bereiche 21, 23 umfassen. Dabei grenzt der mittlere Bereich 22 an einen ersten äußeren Bereich 21 und an einen zweiten äußeren Bereich 23 unmittelbar an. Die zwei äußeren Bereiche 21, 23 umfassen ein jeweils anderes von zwei sich senkrecht zur ersten Richtung R1 erstreckenden Enden des Stromleiters 10. Eine jede Kontaktfläche zwischen dem mittleren Bereich 22 und einem der zwei äußeren Bereiche 21, 23 erstreckt sich senkrecht zur ersten Richtung R1. Die äußeren Bereiche 21, 23 weisen jeweils eine identische Länge D auf, die unterschiedlich gegenüber einer Länge A des mittleren Bereichs 22 ist. Die äußeren Bereiche 21, 23 weisen jeweils eine und dieselbe Breite C auf, die unterschiedlich gegenüber einer Breite B des mittleren Bereichs 22 ist.
Der Stromleiter 10 und folglich auch die drei Bereiche 21, 22, 23 weisen jeweils eine konstante Höhe E auf.
Der Stromleiter 10 umfasst eine U-förmige Aussparung 30, deren Kontur aus drei unmittelbar aufeinanderfolgenden Teilkonturen 31, 32, 33 besteht. Die drei Teilkonturen 31, 32, 33 umfassen eine erste Teilkontur 31 und eine zweite Teilkontur 33, die jeweils senkrecht zur ersten Richtung R1 verlaufen, und eine dritte Teilkontur 32, die parallel zur ersten Richtung R1 verläuft. Die erste Teilkontur 31 grenzt unmittelbar an den ersten äußeren Bereich 21 an. Die zweite Teilkontur 33 grenzt unmittelbar an den zweiten äußeren Bereich 23 an. Die dritte Teilkontur 32 grenzt unmittelbar an den mittleren Bereich 22 an. Durch ein Vorhandensein der Aussparung 30 ist die Breite B des mittleren Bereichs 22 deutlich kleiner als die Breite C jedes äußeren Bereichs 21, 23. Folglich ist auch eine Leiterquerschnittsfläche des mittleren Bereichs 22 deutlich kleiner als eine Leiterquerschnittsfläche jedes äußeren Bereichs 21, 23.
Zwischen der Länge A des mittleren Bereichs 22, der Breite B des mittleren Bereichs 22 und der Höhe E des Stromleiters 10 kann beispielsweise eine im Folgenden angegebene erste Relation (1) bestehen:

$$A/(B \cdot E) \leq 1{,}6 \cdot L0^{-1} \qquad\qquad (1)$$

In der Relation (1) ist mit L0 eine erste Längeneinheit bezeichnet, die mit einer Längeneinheit übereinstimmt, in der die Länge A des mittleren Bereichs 22, die Breite B des mittleren Bereichs 22 und die Höhe E des Stromleiters 10 jeweils angegeben werden.
Zwischen der Breite C jedes äußeren Bereichs 21, 23 und der Länge D jedes äußeren Bereichs 21, 23 kann beispielsweise eine im Folgenden angegebene zweite Relation (2) bestehen:

$$C \leq 2 \cdot D \qquad\qquad (2)$$

Der Stromsensor gemäß der ersten Ausführungsform umfasst einen Spannungssensor, der zwei Terminals 41, 42 aufweist und dazu ausgebildet ist, eine erste Spannung, die zwischen den zwei Terminals 41, 42 anliegt und gleichzeitig über einem Messbereich des Stromleiters 10 abfällt, zu messen. Ferner umfasst der Stromsensor eine Auswerteeinheit (nicht dargestellt), die dazu ausgebildet ist, einen aktuellen Stromwert des ersten Stroms I in Abhängigkeit von einem aktuellen Spannungswert der ersten Spannung zu bestimmen.

Bei dem Stromsensor gemäß der ersten Ausführungsform stimmt der Messbereich mit dem mittleren Bereich 22 überein. Deswegen wird im Folgenden bei dem Stromsensor gemäß der ersten Ausführungsform auch für den Messbereich das Bezugszeichen 22 verwendet.

Die zwei Terminals 41, 42 können beispielsweise aus einem gegenüber dem ersten Material unterschiedlichen zweiten Material, insbesondere aus Kupfer sein.

Die zwei Terminals 41, 42 umfassen ein in dem ersten äußeren Bereich 21 angeordnetes erstes Terminal 41 und ein in dem zweiten äußeren Bereich 23 angeordnetes zweites Terminal 42. Die zwei Terminals 41, 42 sind jeweils in einem an die Aussparung 30 unmittelbar angrenzenden Randteilbereich des jeweiligen äußeren Bereich 21, 23 so angeordnet, dass eine minimale elektrisch leitende Verbindungsstrecke 35 zwischen den zwei Terminals 41, 42 an die Kontur der Aussparung 30 unmittelbar angrenzt und eine und dieselbe Länge wie die Kontur der Aussparung 30 aufweist. Da die Länge A des mittleren Bereichs 22 kleiner als die Länge der minimalen elektrisch leitenden Verbindungsstrecke 35 zwischen den Terminal 41, 42 ist, ist folglich auch ein geometrischer Abstand zwischen den Terminals 41, 42 kleiner als die Länge der minimalen elektrisch leitenden Verbindungsstrecke 35 zwischen den Terminals 41, 42.

Ein Teil der minimalen elektrische Verbindungsstrecke 35 zwischen den zwei Terminals 41, 42 verläuft entlang des mittleren Bereichs 22 und erstreckt sich parallel zur ersten Richtung R1. Teile der minimalen elektrischen Verbindungsstrecke 35 zwischen den zwei Terminals 41, 42, die nicht über den mittleren Bereich 22 verlaufen, verlaufen entlang der zwei äußeren Bereiche 21, 23 und erstrecken sich senkrecht zur ersten Richtung R1. Aus diesem Grund ist die zwischen den zwei Terminals 41, 42 anliegende erste Spannung gleich einer Spannung, die über dem mittleren Bereich 22 und folglich auch über dem Messbereich 22 abfällt.

Eine Stromdichte des ersten Stromes I, die in den die zwei Terminals 41, 42 umfassenden Randteilbereichen der zwei äußeren Bereiche 21, 23 vorkommt, ist wesentlich kleiner als eine Stromdichte, die sonst in dem Stromleiter 10 vorkommt. Die in diesen Randteilbereichen vorkommende Stromdichte des ersten Stroms I kann beispielsweise um vier bis fünf Größenordnungen kleiner als die Stromdichte sein, die sonst in dem Stromleiter 10 vorkommt. Folglich fließt kein Strom über die zwei Terminals 41, 42, wodurch ein lokales Schmelzen der Terminals 41, 42 und eine dabei entstehende Diffusion des ersten und des zweiten Materials ineinander vermieden wird.

Durch das Vorhandensein der Aussparung 30 wird erreicht, dass die Leiterquerschnittsfläche des mittleren Bereichs 22 deutlich kleiner als die Leiterquerschnittsfläche jedes äußeren Bereichs 21, 23 ist. Folglich wird durch das Vorhandensein der Aussparung 30 erreicht, dass der erste Widerstand des mittleren Bereichs 22 deutlich größer als ein Widerstand des mittleren Bereichs 22 ist, der in einem Fall vorkommen würde, in dem der Stromleiter 10 keine Aussparung 30 aufweist. Eine Vergrößerung des ersten Widerstands führt zu einer Vergrößerung von mittels des Spannungssensors zu messenden Spannungswerten der ersten Spannung und folglich auch zu einer Senkung eines aufgrund einer begrenzten Auflösung des Spannungssensors auftretenden relativen Messfehlers der zu messenden Spannungswerte der ersten Spannung. Um optimale Werte der zu messenden Spannungswerte der ersten Spannung zu erreichen, werden Widerstandswerte des ersten Widerstands benötigt, die beispielsweise zwischen $70 \cdot 10^{-6}\ \Omega$ und $400 \cdot 10^{-6}\ \Omega$ liegen. Um minimale Werte der zu messenden Spannungswerte der ersten Spannung zu erreichen, die noch mit einem gewissen Genauigkeitsgrad gemessen werden können, werden Widerstandswerte des ersten Widerstands benötigt, die beispielsweise zwischen $20 \cdot 10^{-6}\ \Omega$ und $50 \cdot 10^{-6}\ \Omega$ liegen.

Der Stromsensor gemäß der ersten Ausführungsform umfasst zwei jeweils als Heißleiter ausgebildete Temperatursensoren 51, 52. Ein jeder der zwei Temperatursensoren 51, 52 steht in thermischem Kontakt mit jeweils einem diesem zugeordneten Ende von zwei sich senkrecht zur ersten Richtung R1 erstreckenden Enden des Messbereichs 22 und ist dazu ausgebildet, eine Temperatur des diesem zugeordneten Endes des Messbereichs 22 zu messen. Ferner ist die Auswerteeinheit dazu ausgebildet, einen aktuellen Stromwert des ersten Stroms I auch in Abhängigkeit von aktuellen Temperaturwerten der mittels der Temperatursensoren 51, 52 gemessenen Temperaturen und von aktuellen Temperaturmessfehlern der zwei Temperatursensoren 51, 52 zu bestimmen. Jeder Temperatursensor 51, 52 kann eine Temperatur messen, die einen minimalen Temperaturwert von beispielsweise 0°C, das heißt von 273,15 K und einen maximalen Temperaturwert von beispielsweise 110°C, das heißt von 383,15 K annehmen kann.

Die zwei Temperatursensoren 51, 52 umfassen einen ersten Temperatursensor 51 und einen zweiten Temperatursensor 52. Der erste Temperatursensor 51 ist an einer Schnittstelle zwischen einer ersten Linie L1 und einer zweiten Linie L2 angeordnet. Die erste Linie L1 verläuft entlang des ersten äußeren Bereichs 21 parallel zu seiner Breite C und grenzt an einen der Aussparung 30 zugewandten Randbereich des ersten Terminals 41 an. Die zweite Linie L2 verläuft entlang des mittleren Bereichs 22 parallel zu seiner Länge A und teilt die Breite B des mittleren Bereichs 22 in zwei Teilbreiten, deren Längenverhältnis insbesondere 1 beträgt. Dabei kann das Längenverhältnis der zwei Teilbreiten um maximal 20% von 1 abweichen. Der zweite Temperatursensor 52 ist an einer Schnittstelle zwischen der zweiten Linie L2 und einer dritten Linie L3 angeordnet. Die dritte Linie L3 verläuft entlang des zweiten äußeren Bereichs 23 parallel zu seiner Breite C und grenzt an einen der Aussparung 30 zugewandten Randbereich des zweiten Terminals 42 an. Durch eine zuvor beschriebene Anordnungsart der zwei Temperatursensoren 51, 52 wird erreicht, dass jeder Temperatursensor 51, 52 in thermischem Kontakt mit einem diesem zugeordneten Ende von zwei sich senkrecht zur ersten Richtung erstreckenden Enden des mittleren Bereichs 22 und folglich mit dem diesem zugeordneten Ende des Messbereichs 22 steht. Folglich ist ein erstes Ende der zwei Enden des Messbereichs 22 dem ersten Temperatursensor 51 und ein zweites Ende der zwei Enden des Messbereichs 22 dem zweiten Temperatursensor 52 zugeordnet.

Eine Bestimmung des aktuellen Temperaturmessfehlers jedes Temperatursensors 51, 52 wird im Folgenden näher beschrieben. Hierbei zu berücksichtigen ist, dass ein thermischer Übergangswiderstand zwischen jedem Temperatursensor 51, 52 und dem diesem zugeordneten Ende des Messbereichs 22 ungleich Null ist. Ferner ist hierbei zu berücksichtigen, dass wenn der Stromleiter 10 von dem ersten Strom I durchflossen wird, eine allmähliche Erhöhung einer tatsächlichen Temperatur jedes der zwei Enden des Messbereichs 22 erfolgt.

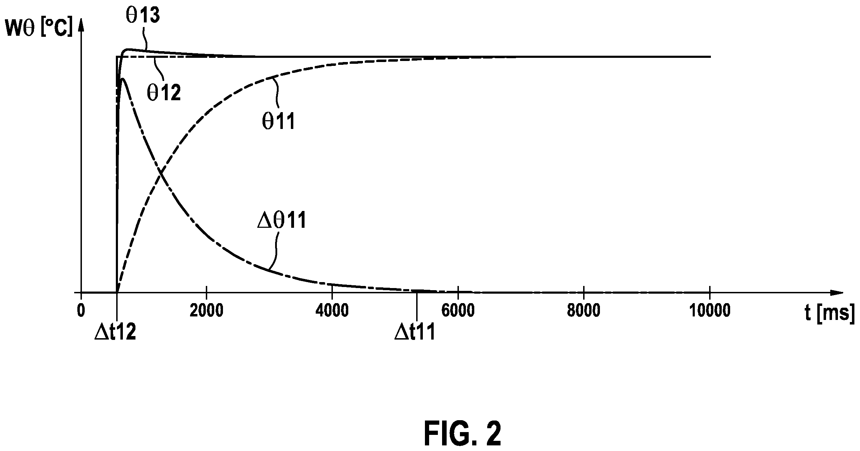

Ein Verhalten jedes Temperatursensors 51, 52, das dann auftritt, wenn der Stromleiter 10 von dem ersten Strom I durchflossen wird, wird im Folgenden am Beispiel des ersten Temperatursensors 51 und in Zusammenhang mit der Figur 2 näher erläutert.

Wenn der Stromleiter 10 von dem ersten Strom I durchflossen wird, wird der erste Temperatursensor 51 bei einer durch diesen aktuell durchgeführten ersten Temperaturmessung eine erste Temperatur $\theta 11$ mit einem zeitabhängigen Verlauf messen. Figur 2 zeigt den Verlauf der ersten Temperatur $\theta 11$ in Abhängigkeit von der in Millisekunden gemessenen Zeit t. Die erste Temperatur $\theta 11$ nimmt erst an einem Ende eines gleichzeitig mit der ersten Temperaturmessung beginnenden ersten Verzögerungszeitraums $\Delta t11$ einen aktuellen Temperaturwert der tatsächlichen Temperatur des dem ersten Temperaursensor 51 zugeordneten ersten Endes des Messbereichs 22 an. Eine in der Figur 2 vorkommende Achse W$\theta$ gibt Temperaturwerte in Grad Celsius an.

Da der thermische Übergangswiderstand zwischen dem ersten Temperatursensor 51 und dem ersten Ende des Messbereichs 22 ungleich Null ist, ist der zeitabhängige Verlauf der ersten Temperatur $\theta 11$ stetig während der ersten Temperaturmessung. Wenn der thermische Übergangswiderstand zwischen dem ersten Temperatursensor 51 und dem ersten Ende des Messbereichs 22 gleich Null wäre, würde der erste Temperatursensor 51 bei der ersten Temperaturmessung eine erste gewünschte Temperatur $\theta 12$ mit einem zeitabhängigen unstetigen Verlauf messen. Figur 2 zeigt den Verlauf der ersten gewünschten Temperatur $\theta 12$ in Abhängigkeit von der Zeit t. Die erste gewünschte Temperatur $\theta 12$ würde an einem Ende eines gleichzeitig mit der ersten Temperaturmessung beginnenden und gegenüber dem ersten Verzögerungszeitraum $\Delta t11$ wesentlich kürzeren ersten Reaktionszeitraums $\Delta t12$ den aktuellen Temperaturwert der tatsächlichen Temperatur des ersten Endes des Messbereichs 22 annehmen. Der erste Reaktionszeitraum $\Delta t12$ ist ein kürzester Zeitraum, nach Ablauf dessen der erste Temperatursensor 51 eine Änderung einer von diesem gemessenen Temperatur angeben kann. Dabei ist der Verlauf der ersten gewünschten Temperatur $\theta 12$ am Ende des ersten Reaktionszeitraums $\Delta t12$ unstetig und sonst während der ersten Temperaturmessung stetig.

Der Verlauf der ersten Temperatur $\theta 11$ und der ersten gewünschten Temperatur $\theta 12$ ist während des ersten Reaktionszeitraums $\Delta t12$ konstant. Dabei weisen die erste Temperatur $\theta 11$ und die erste gewünschte Temperatur $\theta 12$ während des ersten Reaktionszeitraums $\Delta t12$ jeweils einen konstanten Temperaturwert von beispielsweise 0°C, das heißt, von 273,15 K auf. Ferner wächst der Verlauf der ersten Temperatur $\theta 11$ unmittelbar nach dem Ende der ersten Reaktionszeit $\Delta t12$ und vordem Ende des ersten Verzögerungszeitraums $\Delta t11$ streng monoton mit der Zeit t. Weiterhin ist der Verlauf der ersten Temperatur $\theta 11$ unmittelbar nach dem Ende des ersten Verzögerungszeitraums $\Delta t11$ konstant. Dabei weist die erste Temperatur $\theta 11$ unmittelbar nach dem Ende des ersten Verzögerungszeitraums $\Delta t11$ einen konstanten Temperaturwert an, der gleich dem aktuellen Temperaturwert der tatsächlichen Temperatur des ersten Endes des Messbereichs 22 ist. Auch ist der Verlauf der ersten gewünschten Temperatur $\theta 12$ unmittelbar nach dem Ende des ersten Reaktionszeitraums $\Delta t12$ konstant. Dabei weist die erste gewünschte Temperatur $\theta 12$ unmittelbar nach dem Ende des ersten Reaktionszeitraums $\Delta t12$ einen konstanten Temperaturwert auf, der gleich dem aktuellen Temperaturwert der tatsächlichen Temperatur des ersten Endes des Messbereichs 22 ist.

Zusammenfassend wird der erste Temperatursensor 51 bei der ersten Temperaturmessung die erste Temperatur $\theta 11$ mit einem ersten aktuellen Temperaturmessfehler $\Delta\theta 11$, der aufgrund des sich von Null unterscheidenden thermischen Übergangswiderstands zwischen dem ersten Temperatursensor 51 und dem ersten Ende des Messbereichs 22 entsteht, messen. Figur 2 zeigt einen Verlauf des ersten aktuellen Temperaturmessfehlers $\Delta\theta 11$ in Abhängigkeit von der Zeit t.

Der erste aktuelle Temperaturmessfehler $\Delta\theta 11$ wird derartig in Abhängigkeit von der ersten Temperatur $\theta 11$ und der ersten gewünschten Temperatur $\theta 12$ bestimmt, dass ein zeitabhängiger Verlauf einer Summe zwischen der ersten Temperatur $\theta 11$ und dem ersten aktuellen Temperaturmessfehler $\Delta\theta 11$ den zeitabhängigen Verlauf der ersten gewünschten Temperatur $\theta 11$ sehr gut wiedergibt. Dabei ist die Summe zwischen der ersten Temperatur $\theta 11$ und dem

ersten aktuellen Temperaturmessfehler $\Delta\theta11$ gleich einer ersten korrigierten Temperatur $\theta13$ des ersten Endes des Messbereichs 22. Figur 2 zeigt einen Verlauf der ersten korrigierten Temperatur $\theta13$ in Abhängigkeit von der Zeit t.

Bei der ersten Temperaturmessung werden mehrere Temperaturwerte der ersten Temperatur $\theta13$ zu mehreren unmittelbar nacheinander folgenden Abtastzeitpunkten gemessen. Zwischen einem aktuellen Temperaturwert $\theta13n$ der ersten korrigierten Temperatur $\theta13$ und einem weiteren Temperaturwert $\theta13m$ der ersten korrigierten Temperatur $\theta13$ besteht eine im Folgenden angegebenen dritten Relation (3). Dabei liegt der aktuelle Temperaturwert $\theta13n$ der ersten korrigierten Temperatur $\theta13$ zu einem aktuell vorkommenden Abtastzeitpunkt tn der mehreren Abtastzeitpunkte vor. Ferner liegt der weitere Temperaturwert $\theta13m$ der ersten korrigierten Temperatur $\theta13$ zu einem weiteren Abtastzeitpunkt tm der mehreren Abtastzeitpunkten vor, der zeitlich unmittelbar vor dem aktuell vorkommenden Abtastzeitpunkt tn vorkommt.

$$\theta13n = \theta11n + k11\cdot(\theta11n - \theta11m) - ((tn - tm)/k12)\cdot(\theta13n - \theta13m) \qquad (3)$$

In der dritten Relation (3) wird mit k11 ein erster Korrekturfaktor und mit k12 ein zweiter Korrekturfaktor bezeichnet. Diese zwei Korrekturfaktoren k11, k12 werden mittels des ersten aktuellen Temperaturmessfehlers $\Delta\theta11$ bestimmt.

In der Relation (3) ist mit $\theta11n$ ein aktueller Temperaturwert der ersten Temperatur $\theta11$ bezeichnet, die zu dem aktuell vorkommenden Abtastzeitpunkt tn vorliegt. In der Relation (3) ist mit $\theta11m$ ein weiterer Temperaturwert der ersten Temperatur $\theta11$ bezeichnet, der zu dem weiteren Abtastzeitpunkt tm vorliegt.

Wenn der Stromleiter 10 von dem ersten Strom I durchflossen wird, wird der zweite Temperatursensor 52 bei einer durch diesen aktuell durchgeführten zweiten Temperaturmessung eine zweite Temperatur $\theta21$ mit einem zeitabhängigen Verlauf messen. Die zweite Temperaturmessung erfolgt gleichzeitig mit der ersten Temperaturmessung. Bei der zweiten Temperaturmessung werden mehrere Temperaturwerte der zweiten Temperatur $\theta21$ zu mehreren unmittelbar nacheinander folgenden Abtastzeitpunkten gemessen, die mit den bei der ersten Temperaturmessung vorkommenden Abtastzeitpunkten übereinstimmen. Dabei werden bei der zweiten Temperaturmessung die zweite Temperatur $\theta21$, ein aktueller Temperaturwert $\theta21n$ und ein weiterer Temperaturwert $\theta21m$ der zweiten Temperatur $\theta21$ und eine zweite gewünschte Temperatur $\theta22$ in gleicher Weise definiert, wie die entsprechenden ersten Größen bei der ersten Temperaturmessung definiert werden. Ferner werden bei der zweiten Temperaturmessung auch ein zweiter aktueller Temperaturmessfehler $\Delta\theta21$, eine zweite korrigierte Temperatur $\theta23$ des zweiten Ende des Messbereichs 22, ein aktueller Temperaturwert $\theta23n$ und ein weiterer Temperaturwert $\theta23m$ der zweiten korrigierten Temperatur $\theta23$ in gleicher Weise definiert, wie die entsprechenden ersten Größen bei der ersten Temperaturmessung definiert werden.

Zwischen einem aktuellem Temperaturwert $\theta23n$ der zweiten korrigierten Temperatur $\theta23$ und dem weiteren Temperaturwert $\theta23m$ der zweiten korrigierten Temperatur $\theta23$ besteht eine im Folgenden angegebene vierte Relation (4).

$$\theta23n = \theta21n + k21\cdot(\theta21n - \theta21m) - ((tn - tm)/k22)\cdot(\theta23n - \theta23m) \qquad (4)$$

In der vierten Relation (4) wird mit k21 ein weiterer erster Korrekturfaktor und mit k22 ein weiterer zweiter Korrekturfaktor bezeichnet. Diese zwei Korrekturfaktoren k21, k22 werden mittels des zweiten aktuellen Temperaturmessfehlers $\Delta\theta21$ bestimmt. Der erste Korrekturfaktor k11 und der weitere erste Korrekturfaktor k21 sind einheitslos und können jeweils einen Wert von 25 aufweisen. Der zweite Korrekturfaktor k12 und der weitere zweite Korrekturfaktor k22 können jeweils einen Wert von 40 ms, das heißt, von $40\cdot10^{-3}$ s aufweisen.

Die Auswerteeinheit des Stromsensors gemäß der ersten Ausführungsform der Erfindung ist dazu ausgebildet, den ersten aktuellen Temperaturmessfehler $\Delta\theta11$, wie zuvor beschrieben, mittels der ersten Temperatur $\theta11$ und der ersten gewünschten Temperatur $\theta12$ zu bestimmen. Die Auswerteeinheit des Stromsensors gemäß der ersten Ausführungsform der Erfindung ist ferner dazu ausgebildet, den zweiten aktuellen Temperaturmessfehler $\Delta\theta21$, wie zuvor beschrieben, mittels der zweiten Temperatur $\theta21$ und der zweiten gewünschten Temperatur $\Delta\theta22$ zu bestimmen. Die Auswerteeinheit ist weiterhin dazu ausgebildet, den ersten Korrekturfaktor k11 und den zweiten Korrekturfaktor k12 mittels des ersten aktuellen Temperaturmessfehler $\Delta\theta11$ zu bestimmen. Die Auswerteeinheit ist auch dazu ausgebildet, den weiteren ersten Korrekturfaktor k21 und den weiteren zweiten Korrekturfaktor k22 mittels des zweiten aktuellen Temperaturmessfehlers $\Delta\theta21$ zu bestimmen. Die Auswerteeinheit ist ferner dazu ausgebildet, den aktuellen Temperaturwert $\theta13n$ der ersten korrigierten Temperatur $\theta13$ gemäß der Relation (3) und den aktuellen Temperaturwert $\theta23n$ der zweiten korrigierten Temperatur $\theta23$ gemäß der Relation (4) zu bestimmen.

Die Auswerteeinheit ist auch weiterhin dazu ausgebildet, einen in dem Messbereich 22 vorkommenden Temperaturgradienten zu bestimmen und mittels des Temperaturgradienten einen konstanten Faktor K zu bestimmen. Auch ist die Auswerteeinheit dazu ausgebildet, einen aktuellen Temperaturwert $\theta M1$ einer durchschnittlichen Temperatur $\theta M$

des Messbereichs 22 gemäß einer im Folgenden angegebenen fünften Relation (5) zu bestimmen. Gemäß der fünften Relation (5) wird der aktuelle Temperaturwert $\theta M1$ der durchschnittlichen Temperatur $\theta M$ des Messbereichs 22 in Abhängigkeit von dem konstanten Faktor K und den aktuellen Temperaturwerten $\theta 13n$, $\theta 23n$ der ersten und der zweiten korrigierten Temperatur $\theta 13$, $\theta 23$ bestimmt.

$$\theta M1 = (K/2)\bullet (\theta 13n + \theta 23n) \qquad (5)$$

Die Auswerteeinheit ist ferner dazu ausgebildet, einen aktuellen Widerstandswert R1 eines ersten Widerstands R des Messbereichs 22 gemäß einer im Folgenden angegebenen sechsten Relation (6) zu bestimmen. Gemäß der sechsten Relation (6) wird der aktuelle Widerstandswert R1 des ersten Widerstands R in Abhängigkeit von dem aktuellen Temperaturwert $\theta M1$ und einem vordefinierten Temperaturwert $\theta M2$ der durchschnittlichen Temperatur $\theta M$ des Messbereichs 22, von einem Temperatur-Koeffizienten $K\theta$ des ersten Materials des Messbereichs 22 und von einem vordefinierten Widerstandswert R2 des ersten Widerstands R bestimmt.

$$R1 = R2\bullet (1 + K\theta \bullet (\theta M1 - \theta M2)) \qquad (6)$$

Der vordefinierte Temperaturwert $\theta M2$ der durchschnittlichen Temperatur $\theta M$ des Messbereichs 22 kann einen Wert von beispielsweise 25°C, das heißt von 298,15 K aufweisen. Der Temperatur-Koeffizient $K\theta$ des ersten Materials kann beispielsweise einen Wert von kleiner als 0,0023 $K^{-1}$ aufweisen. Eine relative Änderung $\Delta K\theta/K\theta$ des Temperatur-Koeffizienten $K\theta$ des ersten Materials pro Kelvin kann beispielsweise der Ungleichung $0,99 \leq \Delta K\theta/K\theta \leq 1,01$ genügen. Der vordefinierte Widerstandswert R2 des ersten Widerstands R kann beispielsweise einen Wert von $70\bullet 10^{-6}$ $\Omega$ aufweisen. Ein Widerstandswert des ersten Widerstands R, der bei einem Temperaturwert der durchschnittlichen Temperatur $\theta M$ des Messbereichs 22 von 110°C, das heißt von 383,15 K vorkommt, kann beispielsweise einen Wert von $160\bullet 10^{-6}$ $\Omega$ aufweisen.

Wenn die zwei Terminals 41, 42 aus dem zweiten Material bestehen, ist die Auswerteeinheit dazu ausgebildet, einen aktuellen Spannungswert US1 einer zwischen den zwei Enden des Messbereichs 22 anliegenden Seebeck-Thermospannung US gemäß einer im Folgenden angegebenen siebten Relation (7) zu bestimmen. Gemäß der siebten Relation (7) wird der aktuelle Spannungswert US1 der Seebeck-Thermospannung US in Abhängigkeit von einem ersten Seebeck-Koeffizienten $\alpha 1$ des ersten Materials des Stromleiters 10, von einem zweiten Seebeck-Koeffizienten $\alpha 2$ des zweiten Materials der zwei Terminals 41, 42 des Spannungssensors und von den aktuellen Temperaturwerten $\theta 13n$, $\theta 23n$ der ersten und der zweiten korrigierten Temperatur $\theta 13$, $\theta 23$ bestimmt.

$$US1 = (\alpha 2 - \alpha 1)\bullet (\theta 23n - \theta 13n) \qquad (7)$$

In der siebten Relation (z) wurden Terme, die proportional zu einem Quadrat einer Differenz zwischen dem aktuellen Temperaturwert $\theta 23n$ der zweiten korrigierten Temperaturen $\theta 23$ und dem aktuellen Temperaturwert $\theta 13n$ der ersten korrigierten Temperatur $\theta 13$ vernachlässigt. Der erste Seebeck-Koeffizient $\alpha 1$ kann einen Wert von $3,5 \bullet 10^{-3}$ V/k betragen. Der zweite Seebeck-Koeffizient $\alpha 2$ kann einen Wert von $6,5 \bullet 10^{-3}$ V/k betragen.

Wenn die zwei Terminals aus dem zweiten Material bestehen, ist die Auswerteeinheit dazu ausgebildet, einen aktuellen Spannungswert UK1 einer zweiten Spannung UK gemäß einer im Folgenden angegebenen achten Relation (8) zu bestimmen. Die zweite Spannung UK ergibt sich durch Korrigieren der ersten Spannung UM mittels der Seebeck-Thermospannung US und ist gleich einem Produkt zwischen dem ersten Strom I und dem ersten Widerstand R. Gemäß der achten Relation (8) wird der aktuelle Spannungswert UK1 der zweiten Spannung UK in Abhängigkeit von dem aktuellen Spannungswert UM1 der ersten Spannung UM und dem aktuellen Spannungswert US1 der Seebeck-Thermospannung US bestimmt.

$$UK1 = UM1 - US1 = UM1 - (\alpha 2 - \alpha 1)\bullet (\theta 23n - \theta 13n) \qquad (8)$$

Die siebte und achte Relation (7), (8) gelten für einen Fall, in dem die zwei Terminals 41, 42 aus dem zweiten Material bestehen und in dem der erste Strom entlang der ersten Richtung R1 fließt. Wenn hierbei der erste Strom I entgegengesetzt zur ersten Richtung R1 fließen würde, so wäre die in der siebten und achten Relation (7), (8) vorkommende Differenz zwischen dem aktuellen Temperaturwert $\theta 23n$ der zweiten korrigierten Temperatur $\theta 23$ und dem aktuellen Temperaturwert $\theta 13n$ der ersten korrigierten Temperaturen $\theta 13$ mit einem negativen Vorzeichen behafteten.

Wenn die zwei Terminals aus dem zweiten Material bestehen, ist die Auswerteeinheit dazu ausgebildet, den aktuellen Stromwert I1 des ersten Stroms I gemäß einer im Folgenden angegebenen neunten Relation (9) zu bestimmen. Gemäß der neunten Relation (9) wird der aktuelle Stromwert I1 des ersten Stroms I als Quotient zwischen dem aktuellen Spannungswert UK1 der zweiten Spannung UK und dem aktuellen Widerstandswert R1 des ersten Widerstands R bestimmt.

$$I1 = UK1/R1 \tag{9}$$

Wenn die zwei Terminals 41, 42 aus dem ersten Material bestehen, bestimmt die Auswerteeinheit keine Seebeck-Thermospannung und ist dazu ausgebildet, den aktuellen Stromwert I1 des ersten Stroms I als Quotient zwischen dem aktuellen Spannungswert UM1 der ersten Spannung UM und dem aktuellen Widerstandswert R1 des ersten Widerstands R zu bestimmen.

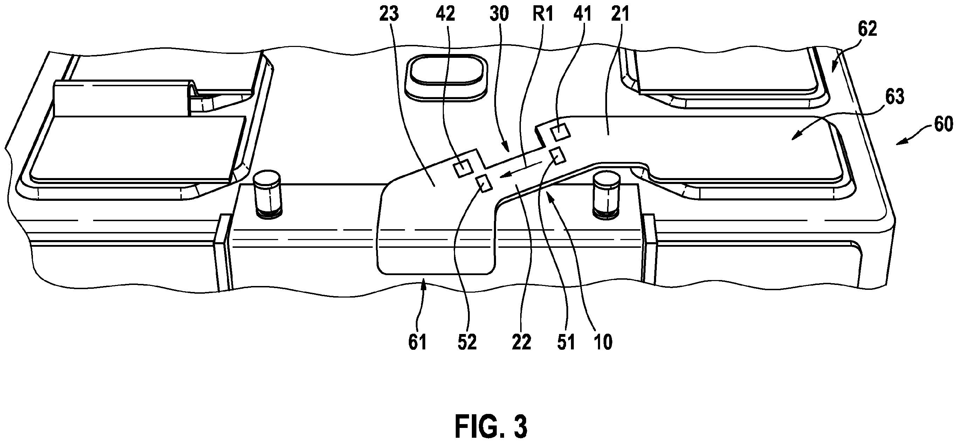

Figur 3 zeigt eine perspektivische Teilansicht eines ersten Batteriemoduls 60 mit mehreren Batteriezellen, einem Stromsensor gemäß der ersten Ausführungsform der Erfindung und einem ersten Verbindungsanschluss 61. Die Batteriezellen des ersten Batteriemoduls sind so angeordnet, dass jeweils eines von zwei Batteriezellterminals einer jeder der Batteriezellen innerhalb einer einzelnen ersten Fläche 62 des ersten Batteriemoduls 60 angeordnet ist. Der erste Verbindungsanschluss 61 ist auf einer zweiten Fläche des ersten Batteriemoduls 60 angeordnet, die an die erste Fläche 62 angrenzt und senkrecht zu dieser verläuft. Der erste Verbindungsanschluss 61 ist ferner an dem ersten Batteriemodul 60 festgeklemmt oder angeschweißt. Zum Schalten des ersten Batteriemoduls 60 in Reihe mit wenigstens einem weiteren ersten Batteriemodul (nicht dargestellt) ist der erste Verbindungsanschluss 61 des ersten Batteriemoduls 60 über eine Stromsammelschiene oder über ein elektrisches Kabel mit einem jeden weiteren ersten Verbindungsanschluss des wenigstens einen weiteren ersten Batteriemoduls verbindbar. Dabei ist jeder weitere erste Verbindungsanschluss in gleicher Weise ausgebildet und an das jeweilige weitere erste Batteriemodul angebracht, wie der erste Verbindungsanschluss 61 ausgebildet und an das ersten Batteriemodul 60 angebracht ist.

Der Stromleiter 10 des Stromsensors gemäß der ersten Ausführungsform ist über seinen ersten äußeren Bereich 21 mit einem auf der ersten Fläche 62 des ersten Batteriemoduls 60 angeordneten Batteriezellterminal 63 einer vorbestimmten der Batteriezellen des ersten Batteriemoduls 60 und über seinen zweiten äußeren Bereich 23 mit dem ersten Verbindungsanschluss 61 verbunden. Zur Vereinfachung der Darstellung aus der Figur 3 wurde nur das mit dem Stromleiter 10 verbundene Batteriezellterminal 63 der vorbestimmten Batteriezelle mit dem entsprechenden Bezugszeichen 63 versehen.

Bei dem in der Figur 3 gezeigten Stromleiter 10, das heißt bei dem Stromleiter 10 des ersten Batteriemoduls 60, sind die zwei äußeren Bereiche 21, 23, der mit dem Messbereich 22 übereinstimmende mittlere Bereich 22, die Aussparung 30, die zwei Terminals 41, 42, die insbesondere als herausragende Spitzen ausgebildet sind, und die Temperaursensoren 51, 52 erkennbar. Durch den Stromleiter 10 des ersten Batteriemoduls 60 kann der erste Strom I entlang der ersten Richtung R1 oder entgegen der ersten Richtung R1 fließen. Folglich kann der durch den Stromleiter 10 des ersten Batteriemoduls 10 fließende erste Strom I ein Lade- oder Entladestrom sein.

Wie zuvor beschrieben, sind die zwei äußere Bereiche des Stromleiters 10 des ersten Batteriemoduls 60 mit unterschiedlich ausgebildeten Elementen 63, 61, das heißt, mit dem innerhalb der ersten Fläche 62 angeordneten Batteriezellterminal 63 der vorbestimmten Batteriezelle des ersten Batteriemoduls 60 und mit dem ersten Verbindungsanschluss 61 verbunden. Aus diesem Grund sind tatsächliche Temperaturen der zwei äußeren Bereiche 21, 23 des Stromleiters 10 des ersten Batteriemoduls 60 und folglich auch tatsächliche Temperaturen der zwei sich senkrecht zu der ersten Richtung R1 erstreckenden Enden des entsprechenden Messbereichs 22 unterschiedlich. Eine Differenz zwischen den tatsächlichen Temperaturen der zwei Enden dieses Messbereichs 22 kann in Abhängigkeit von einer Ausbildungsart der vorbestimmten Batteriezelle des ersten Batteriemoduls 60 und des ersten Verbindungsanschlusses 61 beispielsweise zwischen 10°C und 100°C, das heißt zwischen 10 K und 100 K, liegen. Die Ausbildungsart der vorbestimmten Batteriezelle des ersten Batteriemoduls 60 bezieht sich insbesondere auf eine Kapazität dieser Batteriezelle. Wenn der Stromleiter 10 des ersten Batteriemoduls 60 und der erste Verbindungsanschluss 61 durch eine stoffschlüssige Verbindung, wie zum Beispiel durch Schweißen oder Crimpen, miteinander verbunden sind, beträgt die Differenz zwischen den tatsächlichen Temperaturen der zwei Enden des entsprechenden Messbereichs 22 beispielsweise etwa 10°C. Wenn der Stromleiter 10 des ersten Batteriemoduls 60 und der erste Verbindungsanschluss 61 durch eine Steckverbindung miteinander verbunden sind, so ist ein Widerstand einer Verbindungsstelle zwischen dem Stromleiter 10 des ersten Batteriemoduls 60 und dem ersten Verbindungsanschluss 61 größer als bei Verwenden einer stoffschlüssigen Verbindung. Folglich ist in einem solchen Fall auch die Differenz zwischen den tatsächlichen Temperaturen der zwei Enden des entsprechenden Messbereichs 22 größer.

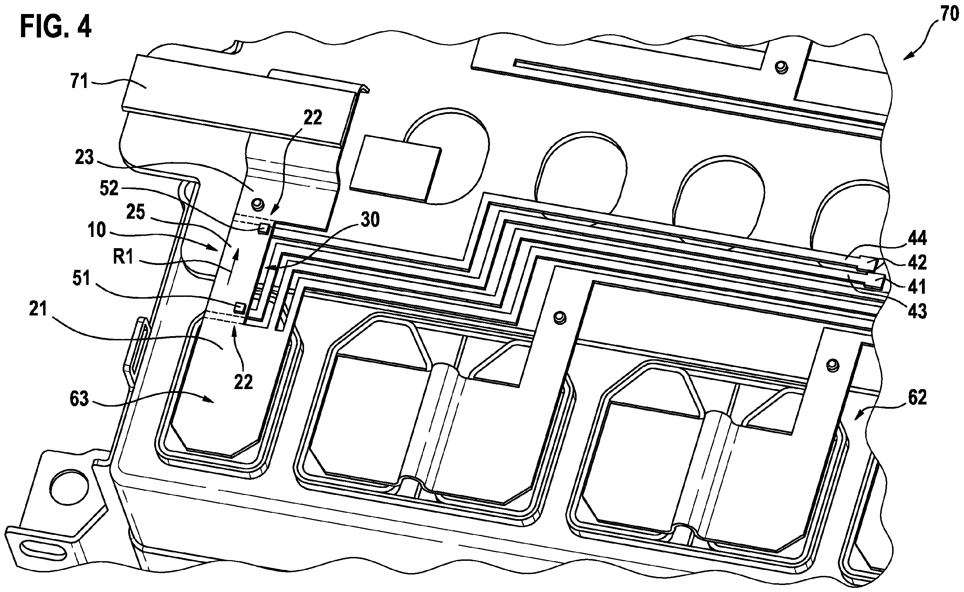

Figur 4 zeigt eine perspektivische Teilansicht eines zweiten Batteriemoduls 70 mit einem Stromsensor gemäß der zweiten Ausführungsform der Erfindung und einem zweiten Verbindungsanschluss 71. Das zweite Batteriemodul 70 unterscheidet sich gegenüber dem ersten Batteriemodul 60 in einer Ausbildungsart des Stromsensors gemäß der zweiten Ausführungsform und in einer Ausbildungs- und Anbringungsart des zweiten Verbindungsanschlusses 71. Sonst ist das zweite Batteriemodul 70 in gleicher Weise wie das erste Batteriemodul 60 ausgebildet.

Die Stromsensoren gemäß der ersten und der zweiten Ausführungsform unterscheiden sich durch eine Anordnungsart der zwei Terminals 41, 42 und der zwei Temperatursensoren 51, 52. Der Stromsensor gemäß der zweiten Ausführungsform umfasst einen Messbereich 25, der unterschiedlich gegenüber dem Messbereich 22 des Stromsensors gemäß der ersten Ausführungsform definiert ist. Der Stromsensor gemäß der zweiten Ausführungsform umfasst eine Auswerteeinheit, deren Funktionalität unterschiedlich gegenüber einer Funktionalität der Auswerteeinheit des Stromsensors gemäß der ersten Ausführungsform ist. Sonst sind die zwei Stromsensoren in gleicher Weise ausgebildet. Der Stromleiter 10 des Stromsensors gemäß der zweiten Ausführungsform ist in gleicher Weise an dem zweiten Batteriemodul 70 angebracht, in welcher auch der Stromleiter 10 des Stromsensors gemäß der ersten Ausführungsform an dem ersten Batteriemodul 70 angebracht ist.

Der zweite Verbindungsanschluss 71 ist auf der ersten Fläche 62 des zweiten Batteriemoduls 70 angeordnet. Zum Schalten des zweiten Batteriemoduls 70 in Reihe mit einem benachbarten weiteren zweiten Batteriemodul (nicht dargestellt) ist der zweite Verbindungsanschluss 71 über eine Steckverbindung mit einem weiteren zweiten Verbindungsanschluss des benachbarten weiteren zweiten Batteriemoduls verbindbar. Alternativ kann anstelle dieser Steckverbindung eine Schweißverbindung verwendet werden. Dabei ist der weitere zweite Verbindungsanschluss in gleicher Weise ausgebildet und an dem weiteren zweiten Batteriemodul angebracht, wie der zweite Verbindungsanschluss 71 ausgebildet und an dem zweiten Batteriemoduls 70 angebracht ist.

Bei dem Stromsensor gemäß der zweiten Ausführungsform sind die zwei Terminals 41, 42 außerhalb des Stromleiters 10 angeordnet. Ferner stimmt der Messbereich 25 des Stromsensors gemäß der zweiten Ausführungsform mit einem Teilbereich des mittleren Bereichs 22 des Stromleiters 10 überein. Dabei ist das erste Terminal 41 über eine erste Messleitung 43 mit einem ersten Ende von zwei sich senkrecht zu ersten Richtung R1 erstreckenden zwei Enden des Messbereichs 25 verbunden. Ferner ist das zweite Terminal 42 über eine zweite Messleitung 44 mit einem zweiten Ende der zwei Enden des Messbereichs 25 verbunden.

Bei dem Stromsensor gemäß der zweiten Ausführungsform verläuft eine minimale Verbindungsstrecke zwischen den zwei Terminals 41, 42 über die zwei Messleitungen 43, 44 und über den Messbereich 25. Ein über den Messbereich 25 verlaufender Teil der minimalen Verbindungsstrecke zwischen den zwei Terminals 41, 42 erstreckt sich parallel zu der ersten Richtung R1. Da über den Messleitungen 43, 44 keine Spannung abfällt, ist auch bei dem Stromsensor gemäß der zweiten Ausführungsform eine zwischen den zwei Terminals 41, 42 anliegende erste Spannung gleich einer über dem Messbereich 25 abfallenden Spannung.

Der erste Temperatursensor 51 ist in thermischem Kontakt mit einem diesem zugeordneten ersten Ende der zwei Enden des Messbereichs 25. Der zweite Temperatursensor 51 ist in thermischem Kontakt mit einem diesem zugeordneten zweiten Ende der zwei Enden des Messbereichs 25. Die Temperatursensoren 51, 52 sind jeweils angrenzend an der Aussparung 30 angeordnet. Das bedeutet, dass jeder Temperatursensor 51, 52 auch hier dazu ausgebildet ist, eine Temperatur des diesem zugeordneten Endes des Messbereichs 25 des Stromleiters 10 zu messen.

Bei dem Stromsensor gemäß der zweiten Ausführungsform steht der Stromleiter 10 nicht direkt mit den Terminals 41, 42 in Verbindung. Hier ist der Stromleiter 10 über die zwei Messleitungen 43, 44 mit den Terminals 41, 42 verbunden. Das bedeutet, dass, bei dem zweiten Batteriemodul 70 die Terminals 41, 42 jeweils eine Temperatur aufweisen, die gleich einer Temperatur des zweiten Batteriemoduls 70 und unterschiedlich gegenüber jeder Temperatur eines der zwei Enden des Messbereichs 25 ist.

Da bei dem Stromsensor gemäß der zweiten Ausführungsform die Temperaturen der zwei Terminals 41, 42 gleich sind, liegt zwischen diesen zwei Terminals 41, 42 keine Seebeck-Thermospannung an. Bei dem Stromsensor gemäß der zweiten Ausführungsform ist folglich die erste Spannung gleich mit einem Produkt zwischen dem ersten Strom I und einem aktuellen Widerstandswerts eines ersten Widerstands des entsprechenden Messbereichs 25.

Die Auswerteeinheit des Stromsensors gemäß der zweiten Ausführungsform ist dazu ausgebildet, den aktuellen Stromwert des ersten Stroms I als Quotienten zwischen dem aktuellen Spannungswert der ersten Spannung und einem aktuellen Widerstandswert des ersten Widerstands des entsprechenden Messbereichs 25 zu bestimmen. Auch ist die Auswerteeinheit des Stromsensors gemäß der zweiten Ausführungsform dazu ausgebildet, den ersten Widerstand des Messbereichs 25 des entsprechenden Stromsensors in gleicher Weise zu bestimmen, wie die Auswerteeinheit gemäß der ersten Ausführungsform den aktuelle Widerstandwert des ersten Widerstands des Messbereichs 22 des entsprechenden Stromsensors bestimmt.

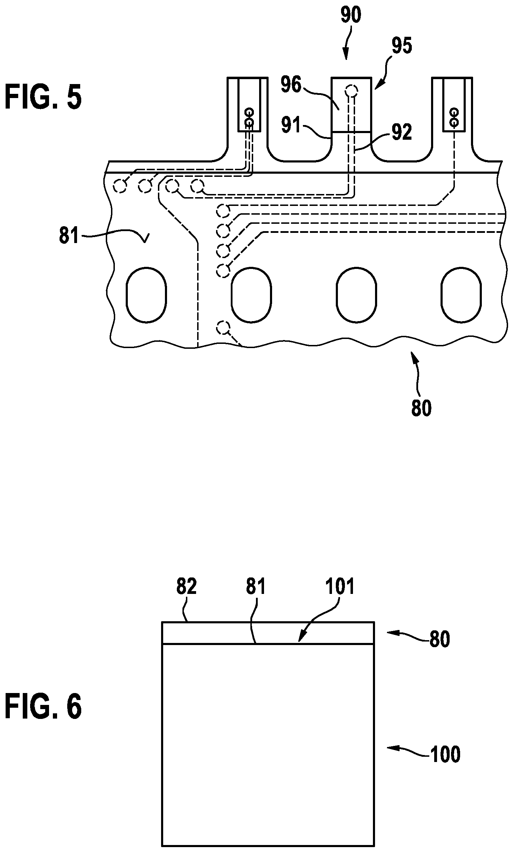

Figur 5 zeigt eine Teilrückansicht einer Leiterplatteneinheit mit einer insbesondere aus flexiblem Material ausgebildeten Leiterplatte 80, deren rückseitige Fläche 81 in der Figur 5 teilweise dargestellt ist. Auf einer parallel zu der rückseitigen Fläche 81 verlaufenden vorderseitigen Fläche der Leiterplatte 80 ist ein Stromsensor (nicht dargestellt) gemäß der ersten Ausführungsform der Erfindung aufgebracht. Alternativ dazu kann auf der vorderseitigen Fläche der Leiterplatte 80 ein Stromsensor (nicht dargestellt) gemäß der zweiten Ausführungsform der Erfindung aufgebracht sein.

Die Leiterplatteneinheit umfasst ein Kontaktelement 90 mit einem Trägerelement 91, das an einer senkrecht zu der rückseitigen Fläche 81 der Leiterplatte 80 verlaufenden Seitenfläche der Leiterplatte 80 angebracht ist und zwei gegenüberliegende Flächen aufweist. Dabei grenzt eine rückseitige Fläche der zwei gegenüberliegenden Flächen des Trägerelements 91 an die rückseitige Fläche 81 der Leiterplatte 80. Ferner grenzt eine vorderseitige Fläche der zwei gegenüberliegenden Flächen des Trägerelements 91 an die vorderseitige Fläche der Leiterplatte 80.

Das Kontaktelement 90 umfasst weiterhin eine Leiste 92 aus elektrisch leitfähigem Material. Die Leiste 92 ist auf der rückseitigen Fläche des Trägerelements 91 aufgebracht. Ferner ist die Leiste 92 mit dem ersten äußeren Bereich 21 des Stromleiters 10 des auf der vorderseitigen Fläche der Leiterplatte 80 aufgebrachten Stromsensors verbunden. Die Leiste 92 kann beispielsweise aus Kupfer gebildet sein und beim Herstellen der Leiterplatteneinheit mittels Ätzens aufgebracht werden.

Das Kontaktelement 90 umfasst ferner eine Klebevorrichtung 95 mit zwei gegenüberliegenden Klebeflächen 96, die parallel zueinander verlaufen und eine erste Klebefläche und eine zweite Klebefläche 96 umfassen. Die Klebevorrichtung 95 ist auf der rückseitigen Fläche des Trägerelements 91 angeordnet und über die erste Klebefläche auf der Leiste 92 geklebt. Dabei ist ein für die Klebevorrichtung 90 verwendeter Klebstoff aus einem elektrisch leitfähigen Material ausgebildet. Die Klebevorrichtung 95 ist als doppelseitiges Klebeband ausgebildet. Alternativ dazu kann zum Erzeugen der Klebevorrichtung 95 ein elektrisch leitfähiger Klebstoff auf der Leiste 92 mittels eines Spenders verteilt werden.

Figur 6 zeigt eine Seitenansicht eines dritten Batteriemoduls 100 mit einer zuvor beschriebenen Leiterplatteneinheit. Das dritte Batteriemodul 100 umfasst ferner mehrere Batteriezellen (nicht dargestellt), die so angeordnet sind, dass jeweils eines von zwei Batteriezellterminals einer jeder der Batteriezellen innerhalb einer einzelnen ersten Fläche 101 des dritten Batteriemoduls 100 angeordnet ist.

Die Leiterplatteneinheit ist so angeordnet, dass die rückseitige Fläche 81 ihrer Leiterplatte 80 an die erste Fläche 101 des dritten Batteriemoduls 100 angrenzt. Dabei wird das Kontaktelement 90 der Leiterplatteneinheit über die zweite Klebefläche 96 seiner Klebevorrichtung 90 an einem auf der ersten Fläche 101 des dritten Batteriemoduls 100 angeordneten Batteriezellterminal einer vorbestimmten der Batteriezellen des dritten Batteriemoduls 100 geklebt. Dadurch wird der erste äußere Bereich 21 des Stromleiters 10 des auf der vorderseitigen Fläche 82 der Leiterplatte 80 aufgebrachten Stromsensors mit dem auf der ersten Fläche 101 des dritten Batteriemoduls 100 angeordneten Batteriezellterminal der vorbestimmten Batteriezelle des dritten Batteriemoduls 100 verbunden.

Das dritte Batteriemodul 100 umfasst einen dritten Verbindungsanschluss (nicht dargestellt), der in gleicher Weise ausgebildet und an dem dritten Batteriemodul 100 angebracht ist, wie der erste Verbindungsanschluss 61 ausgebildet und an dem ersten Batteriemodul 60 angebracht ist. Alternativ kann der dritte Verbindungsanschluss in gleicher Weise ausgebildet und an dem dritten Batteriemodul 100 angebracht sein, wie der zweite Verbindungsanschluss 71 ausgebildet und an dem zweiten Batteriemodul 70 angebracht ist.

Ferner ist der Stromleiter 10 des auf der vorderen Fläche 82 der Leiterplatte 80 aufgebrachten Stromsensors über seinen zweiten äußeren Bereich 23 mit dem dritten Verbindungsanschluss des dritten Batteriemoduls 100 verbunden.

Neben der voranstehenden schriftlichen Offenbarung wird hiermit zur weiteren Offenbarung von Ausführungsformen der Erfindung ergänzend auf die Darstellung in den Figuren 1 bis 6 Bezug genommen.

**Patentansprüche**

1. Stromsensor mit einem Stromleiter (10), durch den ein erster Strom (I) parallel zu einer ersten Richtung (R1) fließen kann, wobei der Stromleiter (10) drei entlang der ersten Richtung (R1) unmittelbar aufeinanderfolgende Bereiche (21,22, 23) umfasst, wobei ein mittlerer Bereich (22) der drei Bereiche (21, 22, 23) eine Leiterquerschnittsfläche aufweist, die kleiner als eine Leiterquerschnittsfläche eines jeden von zwei äußeren Bereichen (21, 23) der drei Bereiche (21, 22, 23) ist, wobei ein Spannungssensor des Stromsensors zwei Terminals (41, 42) umfasst und dazu ausgebildet ist, eine zwischen den zwei Terminals (41, 42) anliegende erste Spannung zu messen, wobei die zwei Terminals (41, 42) derartig angeordnet sind, dass eine minimale elektrisch leitende Verbindungsstrecke (35) zwischen den zwei Terminals (41, 42) teilweise über einen Messbereich (22, 25), der mit dem mittleren Bereich (22) oder mit einem Teilbereich (25) des mittleren Bereichs (22) übereinstimmt, verläuft und die erste Spannung gleich einer über dem Messbereich (22, 25) abfallenden Spannung ist, wobei eine Auswerteeinheit des Stromsensors dazu ausgebildet ist, einen aktuellen Stromwert des ersten Stroms (I) in Abhängigkeit von einem aktuellen Spannungswert der ersten Spannung und von einem vordefinierten Widerstandswert eines ersten Widerstands des Messbereichs (22, 25) zu bestimmen, aufweisend zwei jeweils insbesondere als Heißleiter ausgebildete Temperatursensoren (52, 52), wobei ein jeder der Temperatursensoren (51, 52) in thermischem Kontakt mit jeweils einem diesem zugeordneten Ende von zwei sich senkrecht zur ersten Richtung (R1) erstreckenden Enden des Messbereichs (22, 25) steht, **dadurch gekennzeichnet, dass** ein jeder der Temperatursensoren (51,52) dazu ausgebildet ist, eine Temperatur ($\theta$11) des diesem zugeordneten Endes des Messbereichs (22, 25) zu messen, wobei die Auswerteeinheit dazu ausgebildet ist, den aktuellen Stromwert des ersten Stroms (I) ferner in Abhängigkeit von zwei Parametern zu bestimmen, die jeweils von einem aktuellen Temperaturwert der von einem anderen der Temperatursensoren (51, 52) gemessenen Temperatur ($\theta$11) abhängig sind.

2. Stromsensor nach Anspruch 1, **dadurch gekennzeichnet, dass** die zwei äußeren Bereiche (21, 23) eine jeweils andere von zwei sich senkrecht zur ersten Richtung (R1) erstreckenden Enden des Stromleiters (10) umfassen und sich eine jede Kontaktfläche zwischen dem mittleren Bereich (22) und einem der zwei äußeren Bereiche (21, 23) senkrecht zur ersten Richtung (R1) erstreckt, wobei ein Leiterquerschnittsverlauf des Stromleiters (10) entlang der ersten Richtung (R1) an jeder Kontaktfläche unstetig ist.

3. Stromsensor nach einem der Ansprüche 1 oder 2, **dadurch gekennzeichnet, dass** ein Quotient zwischen der Leiterquerschnittsfläche des mittleren Bereichs (22) und der Leiterquerschnittsfläche jedes der zwei äußeren Bereiche (21, 23) kleiner oder gleich einem zwischen 0,1 und 0,9 liegenden ganzzahligen Vielfaches von 0,1 ist und/oder ein Quotient zwischen einer sich parallel zur ersten Richtung (R1) erstreckenden Länge (A) des mittleren Bereichs (22) und der Leiterquerschnittsfläche des mittleren Bereichs (22) kleiner als ein Produkt zwischen 1,6 und einem Kehrwert einer ersten Längeneinheit ist, wobei eine Längeneinheit, in der die Länge (A) des mittleren Bereichs (22) angegeben wird, mit der ersten Längeneinheit übereinstimmt, und eine Flächeneinheit, in der die Leiterquerschnittsfläche des mittleren Bereichs (22) angegeben wird, mit der ersten Längeneinheit zum Quadrat übereinstimmt.

4. Stromsensor nach einem der vorangehenden Ansprüche, **dadurch gekennzeichnet, dass** der Stromleiter (10) plattenförmig ist und/oder ein Höhenverlauf des Stromleiters (10) entlang der ersten Richtung (R1) konstant ist.

5. Stromsensor nach Anspruch 4, **dadurch gekennzeichnet, dass** der Stromleiter (10) in einem parallel zur ersten Richtung (R1) verlaufenden Randbereich eine Aussparung (30) aufweist, deren Kontur aus drei unmittelbar aufeinander folgenden Teilkonturen (31, 32, 33) besteht, wobei eine erste und eine zweite der Teilkonturen (31, 32, 33) jeweils an einen anderen der zwei äußeren Bereiche (21, 23) angrenzen und eine dritte der Teilkonturen (31, 32, 33) parallel zu der ersten Richtung (R1) verläuft und unmittelbar an den mittleren Bereich (22) angrenzt.

6. Stromsensor nach einem der vorangehenden Ansprüche, **dadurch gekennzeichnet, dass** der Messbereich (22) mit dem mittleren Bereich (22) übereinstimmt, die zwei Terminals (41, 42) jeweils in einem anderen der zwei äußeren Bereiche (21, 23) angeordnet sind und die minimale elektrisch leitende Verbindungsstrecke (35) zwischen den zwei Terminals (41, 42) vollständig über den Stromleiter (10) verläuft, oder, dass der Messbereich (22,25) mit dem mittleren Bereich (22) oder mit dem Teilbereich (25) des mittleren Bereichs (22) übereinstimmt, die zwei Terminals (41, 42) außerhalb des Stromleiters (10) angeordnet sind und Teile der minimalen elektrisch leitenden Verbindungsstecke, die nicht über den Messbereich (25) verlaufen, als Messleitungen (43, 44) ausgebildet sind, die außerhalb des Stromleiters (10) verlaufen.

7. Stromsensor nach einem der vorhergehenden Ansprüche, **dadurch gekennzeichnet, dass** der Stromleiter (10) aus einem ersten Material besteht und die Auswerteeinheit dazu ausgebildet ist, den aktuellen Stromwert des ersten Stroms (I) als Quotient zwischen einem aktuellen Spannungswert einer zweiten Spannung und einem aktuellen Widerstandswert des ersten Widerstands zu bestimmen, wobei, wenn die zwei Terminals (41, 42) außerhalb des Stromleiters (10) angeordnet sind oder wenn die zwei Terminals (41, 42) innerhalb des Stromleiters (10) angeordnet sind und aus dem ersten Material bestehen, die Auswerteeinheit dazu ausgebildet ist, den aktuellen Spannungswert der zweiten Spannung gleich mit dem aktuellen Wert der ersten Spannung zu setzen, und, wenn die zwei Terminals (41, 42) innerhalb des Stromleiters (10) angeordnet sind und aus einem gegenüber dem ersten Material unterschiedlichen zweiten Material bestehen, die Auswerteeinheit dazu ausgebildet ist, den aktuellen Spannungswert der zweiten Spannung in Abhängigkeit von dem aktuellen Spannungswert der ersten Spannung und den zwei Parametern zu bestimmen, wobei die Auswerteeinheit weiter dazu ausgebildet ist, den aktuellen Widerstandswert des ersten Widerstands in Abhängigkeit von dem vordefinierten Widerstand des ersten Widerstands und den zwei Parametern zu bestimmen.

8. Stromsensor nach Anspruch 7, **dadurch gekennzeichnet, dass**, wenn die zwei Terminals (41, 42) innerhalb des Stromleiters (10) angeordnet sind und aus dem zweiten Material bestehen, die Auswerteeinheit dazu ausgebildet ist, einen aktuellen Spannungswert einer zwischen den zwei Enden des Messbereichs (22) anliegenden Seebeck-Thermospannung in Abhängigkeit von Seebeck-Koeffizienten des ersten und des zweiten Materials und von den zwei Parametern zu bestimmen und den aktuellen Spannungswert der zweiten Spannung als lineare Kombination zwischen dem aktuellen Spannungswert der ersten Spannung und dem aktuellen Spannungswert der Seebeck-Thermospannung zu bestimmen.

9. Stromsensor nach einem der Ansprüche 7 oder 8, **dadurch gekennzeichnet, dass** die Auswerteeinheit dazu ausgebildet ist, einen in dem Messbereich (22, 25) vorkommenden Temperaturgradienten zu bestimmen, einen aktuellen Temperaturwert einer durchschnittlichen Temperatur des Messbereichs (22, 25) in Abhängigkeit von dem Temperaturgradienten und den zwei Parametern zu bestimmen und den aktuellen Widerstandswert des ersten Widerstands in Abhängigkeit von dem aktuellen und einem vordefinierten Temperaturwert der durchschnittlichen Temperatur des Messbereichs (22, 25), einem Temperatur-Koeffizienten des ersten Materials und dem vordefinierten Widerstandswert des ersten Widerstands zu bestimmen, wobei der aktuelle Widerstandswert des ersten Widerstands mit einem bei dem aktuellen Temperaturwert der durchschnittlichen Temperatur des Messbereichs (22, 25) vorkommenden Widerstandswert des ersten Widerstands übereinstimmt und der vordefinierte Widerstandswert des ersten Widerstands mit einem bei dem vordefinierten Temperaturwert der durchschnittlichen Temperatur des Messbereichs (22, 25) vorkommenden Widerstandswert des ersten Widerstands übereinstimmt.

10. Stromsensor nach einem der vorhergehenden Ansprüche, **dadurch gekennzeichnet, dass** die Auswerteeinheit dazu ausgebildet ist, einen aktuellen Temperaturmessfehler ($\Delta\theta11$) jedes Temperatursensors (51, 52) in Abhängigkeit von einem zeitabhängigen aktuellen Verlauf der von dem jeweiligen Temperatursensor (51, 52) gemessenen Temperatur ($\theta11$) und von einem zeitabhängigen aktuellen Verlauf einer gewünschten Temperatur ($\theta12$), die von dem jeweiligen Temperatursensor (51, 2) in Abwesenheit eines thermischem Übergangswiderstands zwischen dem jeweiligen Temperatursensor (51, 52) und dem diesen zugeordneten Ende des Messbereichs (22, 25) gemessen werden würde, zu bestimmen, wobei die Auswerteeinheit weiter dazu ausgebildet ist, für jeden Temperatursensor (51, 52) einen aktuellen Temperaturwert einer korrigierten Temperatur ($\theta13$) des dem jeweiligen Temperatursensor (51, 52) zugeordneten Endes des Messbereichs (22, 25) in Abhängigkeit von dem aktuellen Temperaturwert der von dem jeweiligen Temperatursensor (51, 52) gemessenen Temperatur ($\theta11$) und von dem aktuellen Temperaturmessfehler ($\Delta\theta11$) des jeweiligen Temperatursensors (51, 52) zu bestimmen, wobei die zwei Parameter jeweils mit einem aktuellen Temperaturwert der korrigierten Temperatur ($\theta13$) eines jeweils anderen der den Temperatursensoren (51, 52) zugeordneten Enden des Messbereichs (22, 25) übereinstimmen.

11. Leiterplatteneinheit mit einer Leiterplatte (80), **gekennzeichnet durch** einen nach einem der vorangehenden Ansprüche ausgebildeten Stromsensor und ein Kontaktelement (90), wobei der Stromsensor auf der Leiterplatte (80) aufgebracht ist und das Kontaktelement (90) an der Leiterplatte (80) angebracht ist und eine Leiste (92) aus elektrisch leitfähigem Material, insbesondere aus Kupfer, und eine doppelseitige Klebevorrichtung (95) mit zwei gegenüberliegenden Klebeflächen (96) aufweist, wobei die Leiste (92) mit einem ersten der zwei äußeren Bereiche (21, 22) des Stromleiters (10) des Stromsensors verbunden ist, die Klebevorrichtung (95) über eine erste der zwei Klebeflächen (96) auf der Leiste (92) geklebt ist und ein für die Klebevorrichtung (95) verwendeter Klebstoff aus einem elektrisch leitfähigen Material ausgebildet ist.

12. Batterie mit mehreren in Reihe geschalteten und jeweils wenigstens eine Batteriezelle aufweisenden Batteriemodulen (60, 70, 100) und wenigstens einem jeweils einem der Batteriemodule (60, 70; 100) zugeordneten und jeweils nach einem der Ansprüche 1 bis 10 ausgebildeten Stromsensor, wobei ein jeder des wenigstens einen Stromsensors über einen ersten der zwei äußeren Bereiche (21, 23) seines Stromleiters (10) mit einem Batteriezellterminal (63) einer vorbestimmten Batteriezelle des diesem zugeordneten Batteriemoduls (60, 70, 100) verbunden ist und über einen zweiten der zwei äußeren Bereiche (21, 23) seines Stromleiters (10) mit einem Verbindungsanschluss (61, 71) des diesem zugeordneten Batteriemoduls (60, 70, 100) verbunden ist, wobei die Batteriemodule (60, 70, 100) über ihre Verbindungsanschlüsse (61, 71) miteinander verbunden sind und der erste Strom (I) durch die Batterie und gleichzeitig durch den Stromleiter (10) jedes Stromsensors fließen kann.

13. Batterie nach Anspruch 12, **gekennzeichnet durch** wenigstens eine Leiterplatteneinheit nach Anspruch 11, wobei eine jede der wenigstens einen Leiterplatteneinheit jeweils demjenigen der Batteriemodule (100) zugeordnet ist, dem auch der auf der Leiterplatte (80) der jeweiligen Leiterplatteneinheit aufgebrachte Stromsensor zugeordnet ist, wobei das Kontaktelement (90) jeder Leiterplatteneinheit über eine zweite der zwei Klebeflächen (96) seiner Klebevorrichtung (95) an dem Batteriezellterminal der vorbestimmten Batteriezelle des der jeweiligen Leiterplatteneinheit zugeordneten Batteriemoduls (100) geklebt ist.

**Claims**

1. Current sensor comprising a current conductor (10) through which a first current (I) can flow in parallel with a first direction (R1), wherein the current conductor (10) comprises three regions (21, 22, 23) directly following one another along the first direction (R1), wherein a central region (22) of the three regions (21, 22, 23) has a conductor cross-sectional area that is smaller than a conductor cross-sectional area of each of two outer regions (21, 23) of the three regions (21, 22, 23), wherein a voltage sensor of the current sensor comprises two terminals (41, 42) and is configured to measure a first voltage applied between the two terminals (41, 42), wherein the two terminals (41, 42) are arranged in such a way that a minimum electrically conductive connection path (35) between the two terminals (41, 42) runs partly across a measurement region (22, 25), which corresponds to the central region (22) or to a subregion (25) of the central region (22), and the first voltage is equal to a voltage dropped across the measurement region (22, 25), wherein an evaluation unit of the current sensor is configured to determine a present current value of the first current (I) depending on a present voltage value of the first voltage and on a predefined resistance value of a first resistance of the measurement region (22, 25), having two temperature sensors (52, 52) in each case configured, in particular, as NTC thermistors, wherein each of the temperature sensors (51, 52) is in thermal contact with in each case one end, which is associated with said temperature sensor, of two ends of the measurement region (22, 25) extending perpendicularly to the first direction (R1), **characterized in that** each of the temperature sensors (51, 52) is configured to measure a temperature ($\theta 11$) of the end, which is associated with said temperature sensor, of the measurement region (22, 25), wherein the evaluation unit is also configured to determine the present current value of the first current (I) depending on two parameters, which are each dependent on a present temperature value of the temperature ($\theta 11$) measured by another of the temperature sensors (51, 52).

2. Current sensor according to Claim 1, **characterized in that** the two outer regions (21, 23) comprise a respective other of two ends of the current conductor (10) that extend perpendicularly to the first direction (R1) and each contact area between the central region (22) and one of the two outer regions (21, 23) extends perpendicularly to the first direction (R1), wherein a conductor cross-sectional profile of the current conductor (10) along the first direction (R1) is discontinuous at each contact area.

3. Current sensor according to either of Claims 1 and 2, **characterized in that** a quotient between the conductor cross-sectional area of the central region (22) and the conductor cross-sectional area of each of the two outer regions (21, 23) is less than or equal to an integer multiple of 0.1 lying between 0.1 and 0.9 and/or a quotient between a length (A) of the central region (22) extending in parallel with the first direction (R1) and the conductor cross-sectional area of the central region (22) is less than a product between 1.6 and a reciprocal value of a first unit of length, wherein a unit of length in which the length (A) of the central region (22) is given corresponds to the first unit of length, and a unit of area in which the conductor cross-sectional area of the central region (22) is given corresponds to the first unit of length squared.

4. Current sensor according to one of the preceding claims, **characterized in that** the current conductor (10) is plate-shaped and/or a height profile of the current conductor (10) along the first direction (R1) is constant.

5. Current sensor according to Claim 4, **characterized in that** the current conductor (10) has a recess (30) in an edge region running in parallel with the first direction (R1), the contour of said recess consisting of three subcontours (31, 32, 33) that directly follow one another, wherein a first and a second of the subcontours (31, 32, 33) each directly adjoin another of the two outer regions (21, 23) and a third of the subcontours (31, 32, 33) runs in parallel with the first direction (R1) and directly adjoins the central region (22).

6. Current sensor according to one of the preceding claims, **characterized in that** the measurement region (22) corresponds to the central region (22), the two terminals (41, 42) are each arranged in another of the two outer regions (21, 23) and the minimum electrically conductive connection path (35) between the two terminals (41, 42) runs entirely across the current conductor (10) or **in that** the measurement region (22, 25) corresponds to the central region (22) or to the subregion (25) of the central region (22), the two terminals (41, 42) are arranged outside of the current conductor (10) and parts of the minimum electrically conductive connection path that do not run across the measurement region (25) are configured as measurement lines (43, 44), which run outside of the current conductor (10).

7. Current sensor according to one of the preceding claims, **characterized in that** the current conductor (10) consists of a first material and the evaluation unit is configured to determine the present current value of the first current (I) as the quotient between a present voltage value of a second voltage and a present resistance value of the first resistance, wherein, when the two terminals (41, 42) are arranged outside of the current conductor (10) or when the two terminals (41, 42) are arranged inside the current conductor (10) and consist of the first material, the evaluation unit is configured to set the present voltage value of the second voltage to be equal to the present value of the first voltage and, when the two terminals (41, 42) are arranged inside the current conductor (10) and consist of a second material that is different to the first material, the evaluation unit is configured to determine the present voltage value of the second voltage depending on the present voltage value of the first voltage and the two parameters, wherein the evaluation unit is furthermore configured to determine the present resistance value of the first resistance depending on the predefined resistance of the first resistance and the two parameters.

8. Current sensor according to Claim 7, **characterized in that**, when the two terminals (41, 42) are arranged inside the current conductor (10) and consist of the second material, the evaluation unit is configured to determine a present voltage value of a Seebeck thermoelectric voltage applied between the two ends of the measurement region (22) depending on Seebeck coefficients of the first and of the second material and on the two parameters and to determine the present voltage value of the second voltage as a linear combination between the present voltage value of the first voltage and the present voltage value of the Seebeck thermoelectric voltage.

9. Current sensor according to either of Claims 7 and 8, **characterized in that** the evaluation unit is configured to determine a temperature gradient occurring in the measurement region (22, 25), to determine a present temperature value of an average temperature of the measurement region (22, 25) depending on the temperature gradient and the two parameters and to determine the present resistance value of the first resistance depending on the present and a predefined temperature value of the average temperature of the measurement region (22, 25), a temperature coefficient of the first material and the predefined resistance value of the first resistance, wherein the present resistance value of the first resistance corresponds to a resistance value of the first resistance occurring at the present temperature value of the average temperature of the measurement region (22, 25) and the predefined resistance value of the first resistance corresponds to a resistance value of the first resistance occurring at the predefined temperature value of the average temperature of the measurement region (22, 25).

10. Current sensor according to one of the preceding claims, **characterized in that** the evaluation unit is configured to determine a present temperature measurement error ($\Delta\theta 11$) of each temperature sensor (51, 52) depending on a time-dependent present profile of the temperature ($\theta 11$) measured by the respective temperature sensor (51, 52) and on a time-dependent present profile of a desired temperature ($\theta 12$), which would be measured by the respective temperature sensor (51, 2) in the absence of a thermal contact resistance between the respective temperature sensor (51, 52) and the end, which is associated with said temperature sensor, of the measurement region (22, 25), wherein the evaluation unit is further configured to determine, for each temperature sensor (51, 52), a present temperature value of a corrected temperature ($\theta 13$) of the end, which is associated with the respective temperature sensor (51, 52), of the measurement region (22, 25) depending on the present temperature value of the temperature ($\theta 11$) measured by the respective temperature sensor (51, 52) and on the present temperature measurement error ($\Delta\theta 11$) of the respective temperature sensor (51, 52), wherein the two parameters each correspond to a present temperature value of the corrected temperature ($\theta 13$) of a respective other of the ends, which are associated with the temperature sensors (51, 52), of the measurement region (22, 25).

11. Printed circuit board unit comprising a printed circuit board (80), **characterized by** a current sensor configured according to one of the preceding claims and a contact element (90), wherein the current sensor is applied to the printed circuit board (80) and the contact element (90) is mounted on the printed circuit board (80) and has a strip (92) of electrically conductive material, in particular of copper, and a double-sided bonding apparatus (95) comprising two opposite bonding areas (96), wherein the strip (92) is connected to a first of the two outer regions (21, 22) of the current conductor (10) of the current sensor, the bonding apparatus (95) is bonded onto the strip (92) by means of a first of the two bonding areas (96) and an adhesive used for the bonding apparatus (95) is formed from an electrically conductive material.

12. Battery comprising a plurality of battery modules (60, 70, 100), which are connected in series and have in each case at least one battery cell, and at least one current sensor in each case associated with one of the battery modules (60, 70, 100) and in each case configured according to one of Claims 1 to 10, wherein each of the at least one current sensor is connected by means of a first of the two outer regions (21, 23) of its current conductor (10) to a battery cell terminal (63) of a predetermined battery cell of the battery module (60, 70, 100) associated therewith and by means of a second of the two outer regions (21, 23) of its current conductor (10) to a connection terminal (61, 71) of the battery module (60, 70, 100) associated therewith, wherein the battery modules (60, 70, 100) are connected to one another by means of their connection terminals (61, 71) and the first current (I) can flow through the battery and at the same time through the current conductor (10) of each current sensor.

13. Battery according to Claim 12, **characterized by** at least one printed circuit board unit according to Claim 11, wherein each of the at least one printed circuit board unit is in each case associated with that one of the battery modules (100) that is also associated with the current sensor applied to the printed circuit board (80) of the respective printed circuit board unit, wherein the contact element (90) of each printed circuit board unit is bonded by means of a second of the two bonding areas (96) of its bonding apparatus (95) to the battery cell terminal of the predetermined battery cell of the battery module (100) associated with the respective printed circuit board unit.

**Revendications**

1. Capteur de courant, comprenant un conducteur de courant (10) par lequel un premier courant (I) peut circuler en parallèle à une première direction (R1), le conducteur de courant (10) comprenant trois zones (21, 22, 23) immédiatement consécutives le long de la première direction (R1), une zone centrale (22) des trois zones (21, 22, 23) présentant une superficie de section transversale de conducteur de courant qui est inférieure à une superficie de section transversale de conducteur de courant de chacune de deux zones extérieures (21, 23) des trois zones (21, 22, 23), un capteur de tension du capteur de courant comprenant deux bornes (41, 42) et étant réalisé pour mesurer une première tension appliquée entre les deux bornes (41, 42), dans lequel les deux bornes (41, 42) sont disposées de telle sorte qu'une voie de liaison (35) électriquement conductrice minimale s'étend entre les deux bornes (41, 42) partiellement à travers une zone de mesure (22, 25) qui coïncide avec la zone centrale (22) ou avec une zone partielle (25) de la zone centrale (22), et la première tension est égale à une tension diminuant au-dessus de la zone de mesure (22, 25), une unité d'évaluation du capteur de courant étant réalisée pour déterminer une valeur de courant actuelle du premier courant (I) en fonction d'une valeur de tension actuelle de la première tension et d'une valeur de résistance prédéfinie d'une première résistance de la zone de mesure (22, 25), présentant respectivement deux capteurs de température (52, 52) réalisés en particulier sous forme de thermistances, chacun des capteurs de température (51, 52) étant en contact thermique avec respectivement une extrémité qui lui est associée parmi deux extrémités de la zone de mesure (22, 25) s'étendant perpendiculairement à la première direction (R1), **caractérisé en ce que** chacun des capteurs de température (51, 52) est réalisé pour mesurer une température ($\theta$11) de l'extrémité de la zone de mesure (22, 25) qui lui est associée, l'unité d'évaluation étant réalisée pour déterminer la valeur de courant actuelle du premier courant (I) en outre en fonction de deux paramètres qui dépendent respectivement d'une valeur de température actuelle de la température ($\theta$11) mesurée par un autre des capteurs de température (51, 52) .

2. Capteur de courant selon la revendication 1, **caractérisé en ce que** les deux zones extérieures (21, 23) comprennent respectivement une autre extrémité parmi deux extrémités du conducteur de courant (10) s'étendant perpendiculairement à la première direction (R1), et chaque surface de contact entre la zone centrale (22) et l'une des deux zones extérieures (21, 23) s'étend perpendiculairement à la première direction (R1), un tracé de section transversale de conducteur de courant du conducteur de courant (10) étant discontinu le long de la première direction (R1) au niveau de chaque surface de contact.

3. Capteur de courant selon l'une quelconque des revendications 1 et 2, **caractérisé en ce qu'**un quotient entre la superficie de section transversale de conducteur de courant de la zone centrale (22) et la superficie de section transversale de conducteur de courant de chacune des deux zones extérieures (21, 23) est inférieur ou égal à un multiple entier de 0,1 compris entre 0,1 et 0,9, et/ou un quotient entre une longueur (A) de la zone centrale (22), s'étendant en parallèle à la première direction (R1), et la superficie de section transversale de conducteur de courant de la zone centrale (22) est inférieur à un produit entre 1,6 et une valeur réciproque d'une première unité de longueur, dans lequel une unité de longueur qui spécifie la longueur (A) de la zone centrale (22) coïncide avec la première unité de longueur, et une unité de surface qui spécifie la superficie de section transversale de conducteur de courant de la zone centrale (22) coïncide avec la première unité de longueur au carré.

4. Capteur de courant selon l'une quelconque des revendications précédentes, **caractérisé en ce que** le conducteur de courant (10) est en forme de plaque et/ou un tracé de hauteur du conducteur de courant (10) le long de la première direction (R1) est constant.

5. Capteur de courant selon la revendication 4, **caractérisé en ce que** le conducteur de courant (10) présente dans une zone marginale s'étendant en parallèle à la première direction (R1) un évidement (30) dont le contour est composé de trois contours partiels (31, 32, 33) immédiatement consécutifs, dans lequel un premier et un deuxième des contours partiels (31, 32, 33) sont adjacents respectivement à une autre des deux zones extérieures (21, 23), et un troisième des contours partiels (31, 32, 33) s'étend en parallèle à la première direction (R1) et est immédiatement adjacent à la zone centrale (22).

6. Capteur de courant selon l'une quelconque des revendications précédentes, **caractérisé en ce que** la zone de mesure (22) coïncide avec la zone centrale (22), les deux bornes (41, 42) sont disposées respectivement dans une autre des deux zones extérieures (21, 23), et la voie de liaison électriquement conductrice minimale (35) s'étend entre les deux bornes (41, 42) entièrement par le conducteur de courant (10), ou **en ce que** la zone de mesure (22, 25) coïncide avec la zone centrale (22) ou avec la zone partielle (25) de la zone centrale (22), les deux bornes (41, 42) sont disposées à l'extérieur du conducteur de courant (10), et des parties de la voie de liaison électriquement conductrice minimale qui ne s'étendent pas à travers la zone de mesure (25) sont réalisées sous forme de lignes de mesure (43, 44) qui s'étendent à l'extérieur du conducteur de courant (10).

7. Capteur de courant selon l'une quelconque des revendications précédentes, **caractérisé en ce que** le conducteur de courant (10) est composé d'un premier matériau, et l'unité d'évaluation est réalisée pour déterminer la valeur de courant actuelle du premier courant (I) comme quotient entre une valeur de tension actuelle d'une deuxième tension et une valeur de résistance actuelle de la première résistance, dans lequel, si les deux bornes (41, 42) sont disposées à l'extérieur du conducteur de courant (10) ou si les deux bornes (41, 42) sont disposées à l'intérieur du conducteur de courant (10) et sont composées du premier matériau, l'unité d'évaluation est réalisée pour faire correspondre la valeur de tension actuelle de la deuxième tension à la valeur actuelle de la première tension, et si les deux bornes (41, 42) sont disposées à l'intérieur du conducteur de courant (10) et sont composées d'un deuxième matériau différent du premier matériau, l'unité d'évaluation est réalisée pour déterminer la valeur de tension actuelle de la deuxième tension en fonction de la valeur de tension actuelle de la première tension et des deux paramètres, l'unité d'évaluation étant en outre réalisée pour déterminer la valeur de résistance actuelle de la première résistance en fonction de la résistance prédéfinie de la première résistance et des deux paramètres.

8. Capteur de courant selon la revendication 7, **caractérisé en ce que**, si les deux bornes (41, 42) sont disposées à l'intérieur du conducteur de courant (10) et sont composées du deuxième matériau, l'unité d'évaluation est réalisée pour déterminer une valeur de tension actuelle d'une tension thermique de Seebeck présente entre les deux extrémités de la zone de mesure (22) en fonction de coefficients Seebeck du premier et du deuxième matériau et des deux paramètres, et pour déterminer la valeur de tension actuelle de la deuxième tension comme une combinaison linéaire entre la valeur de tension actuelle de la première tension et la valeur de tension actuelle de la tension thermique de Seebeck.

9. Capteur de courant selon l'une quelconque des revendications 7 et 8, **caractérisé en ce que** l'unité d'évaluation est réalisée pour déterminer un gradient de température apparaissant dans la zone de mesure (22, 25), pour déterminer une valeur de température actuelle d'une température moyenne de la zone de mesure (22, 25) en fonction du gradient de température et des deux paramètres, et pour déterminer la valeur de résistance actuelle de la première résistance en fonction de la valeur de température actuelle et d'une valeur de température prédéfinie de la température moyenne de la zone de mesure (22, 25), d'un coefficient de température du premier matériau et de la valeur de résistance prédéfinie de la première résistance, la valeur de résistance actuelle de la première résistance coïncidant avec une valeur de résistance de la première résistance apparaissant pour une valeur de température actuelle de la température moyenne de la zone de mesure (22, 25), et la valeur de résistance prédéfinie de la première résistance coïncidant avec une valeur de résistance de la première résistance apparaissant pour une valeur de température prédéfinie de la température moyenne de la zone de mesure (22, 25).

10. Capteur de courant selon l'une quelconque des revendications précédentes, **caractérisé en ce que** l'unité d'évaluation est réalisée pour déterminer une erreur de mesure de température actuelle ($\Delta\theta11$) de chaque capteur de température (51, 52) en fonction d'une évolution actuelle dans le temps de la température ($\theta11$) mesurée par le capteur de température (51, 52) respectif et d'une évolution actuelle dans le temps d'une température souhaitée ($\theta12$) qui serait mesurée par le capteur de température (51, 2) respectif en l'absence d'une résistance de contact thermique entre le capteur de température (51, 52) respectif et l'extrémité de la zone de mesure (22, 25) qui lui est associée, l'unité d'évaluation étant en outre réalisée pour déterminer pour chaque capteur de température (51, 52) une valeur de température actuelle d'une température corrigée ($\theta13$) de l'extrémité de la zone de mesure (22, 25) associée au capteur de température (51, 52) respectif en fonction de la valeur de température actuelle de la température ($\theta11$) mesurée par le capteur de température (51, 52) respectif et d'une erreur de mesure de température actuelle ($\Delta\theta11$) du capteur de température (51, 52) respectif, les deux paramètres coïncidant respectivement avec une valeur de température actuelle de la température corrigée ($\theta13$) d'une autre extrémité respectivement des extrémités de la zone de mesure (22, 25) associées aux capteurs de température (51, 52).

11. Unité de carte de circuits imprimés, comprenant une carte de circuits imprimés (80), **caractérisée par** un capteur de courant réalisé selon l'une quelconque des revendications précédentes et un élément de contact (90), le capteur de courant étant appliqué sur la carte de circuits imprimés (80), et l'élément de contact (90) étant appliqué sur la carte de circuits imprimés (80), et une baguette (92) en matériau électriquement conducteur, en particulier en cuivre, et un dispositif adhésif double face (95) doté de deux surfaces adhésives opposée (96), la baguette (92) étant reliée à une première des deux zones extérieures (21, 22) du conducteur de courant (10) du capteur de courant, le dispositif adhésif (95) étant collé sur la baguette (92) par l'intermédiaire d'une première des deux faces adhésives (96), et un adhésif utilisé pour le dispositif adhésif (95) étant réalisé dans un matériau électriquement conducteur.

12. Batterie, comprenant plusieurs modules de batterie (60, 70, 100) connectés en série et présentant respectivement au moins une cellule de batterie, et au moins un capteur de courant associé respectivement à l'un des modules de batterie (60, 70, 100) et réalisé respectivement selon l'une quelconque des revendications 1 à 10, chacun de l'au moins un capteur de courant étant relié par l'intermédiaire d'une première des deux zones extérieures (21, 23) de son conducteur de courant (10) à une borne de cellule de batterie (63) d'une cellule de batterie prédéterminée du module de batterie (60, 70, 100) associé à celui-ci, et étant relié par l'intermédiaire d'une deuxième des deux zones extérieures (21, 23) de son conducteur de courant (10) à une connexion de liaison (61, 71) du module de batterie (60, 70, 100) qui lui est associé, les modules de batterie (60, 70, 100) étant reliés les uns aux autres par l'intermédiaire de leurs connexions de liaison (61, 71), et le premier courant (I) pouvant circuler à travers la batterie et en même temps à travers le conducteur de courant (10) de chaque capteur de courant.

13. Batterie selon la revendication 12, **caractérisée par** au moins une unité de carte de circuits imprimés selon la revendication 11, dans laquelle chacune de ladite au moins une unité de carte de circuits imprimés est associée respectivement à celui des modules de batterie (100) auquel est associé également le capteur de courant appliqué sur la carte de circuits imprimés (80) de l'unité de carte de circuits imprimés respective, l'élément de contact (90) de chaque unité de carte de circuits imprimés étant collé par l'intermédiaire d'une deuxième des deux surfaces adhésives (96) de son dispositif adhésif (95) sur la borne de cellule de batterie de la cellule de batterie prédéterminée du module de batterie (100) respectivement associé à l'unité de carte de circuits imprimés respective.

**FIG. 1**

EP 3 380 851 B1

**FIG. 2**

EP 3 380 851 B1

**FIG. 3**

EP 3 380 851 B1

# FIG. 4

71

70

22

23

52

25

10

R1

51

21

63

22

30

44

42

41

43

62

EP 3 380 851 B1

**FIG. 5**

90

95

96

91

92

81

80

**FIG. 6**

82    81    101

80

100

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102009011538 A1
- DE 102008061051 A1
- DE 69732004 T2
- DE 102014103343 A1